(19) Europäisches Patentamt
European Patent Office
Office européen des brevets

(11) **EP 4 687 348 A1**

(12) **EUROPEAN PATENT APPLICATION**

(43) Date of publication:
**04.02.2026 Bulletin 2026/06**

(21) Application number: **25185996.3**

(22) Date of filing: **27.06.2025**

(51) International Patent Classification (IPC):
*H04N 25/68* (2023.01)    *H04N 25/771* (2023.01)
*H04N 25/79* (2023.01)

(52) Cooperative Patent Classification (CPC):
**H04N 25/68; H04N 25/771; H04N 25/79;**
H04N 25/532

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **30.07.2024 JP 2024123116**

(71) Applicant: **CANON KABUSHIKI KAISHA**
**Tokyo 146-8501 (JP)**

(72) Inventors:
• **KOBAYASHI, Daisuke**
**Tokyo, 146-8501 (JP)**
• **KUMAGAI, Tomoya**
**Tokyo, 146-8501 (JP)**

(74) Representative: **Canon Europe Limited**
**European Intellectual Property Group**
**4 Roundwood Avenue**
**Stockley Park**
**Uxbridge UB11 1AF (GB)**

(54)  **PHOTOELECTRIC CONVERSION APPARATUS AND EQUIPMENT**

(57)    A photoelectric conversion apparatus according to one disclosure of the present specification is a photoelectric conversion apparatus including a plurality of pixels and a processing circuit configured to process signals read out from the plurality of pixels, in which each of the plurality of pixels includes a photoelectric conversion element, a first amplification unit which includes an input node to which a signal from the photoelectric conversion element is input and which is configured to output an analog signal obtained by amplifying a signal level at the input node, and a holding capacitor unit which is configured to hold the analog signal output from the first amplification unit and which includes a plurality of capacitor elements, the photoelectric conversion apparatus including a selection unit configured to switch the capacitor element to be connected among the plurality of capacitor elements based on an inspection result of a signal output from the holding capacitor unit.

FIG. 5

EP 4 687 348 A1

## Description

TECHNICAL FIELD

The present disclosure relates to a photoelectric conversion apparatus, an equipment, and inspection method of photoelectric conversion apparatus.

BACKGROUND

In a photoelectric conversion apparatus, it is suggested that a global electronic shutter operation is performed to reset photoelectric conversion units arranged in a plurality of respective pixels and read out electric charges from the photoelectric conversion units at the same time. Japanese Patent Laid-Open No. 2023-83030 describes an image capturing apparatus provided with a global electronic shutter function of a voltage holding type in which a signal electric charge is converted into a voltage to be held. In the image capturing apparatus described in Japanese Patent Laid-Open No. 2023-83030, after signal voltages generated in the photoelectric conversion units are held in capacitor elements across all pixels at the same time, the held voltages are sequentially read out to realize the global electronic shutter operation.

In Japanese Patent Laid-Open No. 2023-83030, variations and defects of the capacitor elements have not been reviewed.

SUMMARY

There is a room for further improvement in an accuracy of a signal held by a capacitor element and image capturing performance.

The present disclosure in its first aspect provides a photoelectric conversion apparatus as specified in claim 1. Optional features are specified in claims 2 to 18.

The present disclosure in its second aspect provides an equipment as specified in claim 19.

The present disclosure in its third aspect provides an inspection method of a photoelectric conversion apparatus as specified in claim 20. Optional features are specified in claims 21 and 22.

Features of the present disclosure will become apparent from the following description of embodiments with reference to the attached drawings. The following description of embodiments are described by way of example.

BRIEF DESCRIPTION OF THE DRAWINGS

Fig. 1 is a block diagram for describing a photoelectric conversion apparatus according to a first embodiment.

Fig. 2 is a schematic diagram for describing the photoelectric conversion apparatus according to the first embodiment.

Fig. 3 is a circuit diagram for describing the photoelectric conversion apparatus according to the first embodiment.

Fig. 4 is a circuit diagram of an electric current source of the photoelectric conversion apparatus according to the first embodiment.

Fig. 5 is a circuit diagram of a signal holding memory of the photoelectric conversion apparatus according to the first embodiment.

Fig. 6 is a drive timing chart of the photoelectric conversion apparatus according to the first embodiment.

Fig. 7 is a schematic cross sectional view for describing the photoelectric conversion apparatus according to the first embodiment.

Fig. 8 is a schematic cross sectional view illustrating another example of the photoelectric conversion apparatus according to the first embodiment.

Fig. 9 is a schematic plan view of the signal holding memory of the photoelectric conversion apparatus according to the first embodiment.

Fig. 10 is a schematic plan view of the signal holding memory illustrating another example of the photoelectric conversion apparatus according to the first embodiment.

Fig. 11 is a circuit diagram of the signal holding memory of the photoelectric conversion apparatus according to a second embodiment.

Fig. 12 is a drive timing chart of the photoelectric conversion apparatus according to the second embodiment.

Fig. 13 is a schematic plan view of the signal holding memory of the photoelectric conversion apparatus according to the second embodiment.

Fig. 14 is a circuit diagram of the signal holding memory of the photoelectric conversion apparatus according to a third embodiment.

Fig. 15 is a schematic plan view of the signal holding memory of the photoelectric conversion apparatus according to the third embodiment.

Fig. 16A is a schematic diagram for describing an equipment according to a fourth embodiment.

Fig. 16B is a schematic diagram for describing the equipment according to the fourth embodiment.

Fig. 16C is a schematic diagram for describing the equipment according to the fourth embodiment.

DESCRIPTION OF THE EMBODIMENTS

Modes to be illustrated below are to embody a technical concept of the present disclosure and are not to be limiting aspects of the present disclosure. Sizes and positional relationships of components illustrated in the respective drawings may be exaggerated for the sake of clarity in the description. In the following description, the same components are allocated by the same reference signs, and the description thereof may be omitted.

Hereinafter, embodiments of the present disclosure will be described in detail based on the drawings. Each of the embodiments of the present invention described below can be implemented solely or as a combination of a plurality of the embodiments or features thereof where necessary or where the combination of elements or features from individual embodiments in a single embodiment is beneficial. It is noted that in the following description, terms that indicate specific directions or positions (for example, "up", "down", "right", and "left", and other terms that incorporate these terms) are used when necessary. The use of these terms is for a purpose for ease of understanding the embodiments with reference to the drawings, and a technical scope of the present disclosure is not limited by the meanings of those terms.

In the present specification, a "planar surface" refers to a surface in a direction parallel to a main surface of a substrate. The main surface of the substrate may be a light incidence surface of the substrate including a photoelectric conversion element, a surface where a plurality of ADCs are repeatedly arranged, a bonding surface of a substrate and another substrate in a photoelectric conversion apparatus of a lamination type. In addition, a "plan view" refers to viewing from a direction perpendicular to a light incident surface of a semiconductor layer. Furthermore, a "cross section" refers to a surface in a direction perpendicular to a light incidence surface of a semiconductor layer. In addition, a "cross sectional view" refers to viewing from a direction perpendicular to the light incidence surface of the semiconductor layer. It is noted that in a case where the light incident surface of the semiconductor layer is a rough surface when viewed microscopically, the plan view is defined while the light incident surface of the semiconductor layer when viewed macroscopically is set as a reference.

In each of the embodiments to be described below, as an example of a photoelectric conversion apparatus, an image capturing apparatus will be mainly described. It is noted however that each of the embodiments is not limited to the image capturing apparatus and can be applied to other examples of the photoelectric conversion apparatus. For example, the other examples include a range finding apparatus (apparatus for range finding or the like using focus detection or time of flight (TOF)), a light metering apparatus (apparatus for measurement of a quantity of incident light or the like), and the like.

A metallic member such as a wiring or a pad described in the present specification may be made of an elemental metal of one certain element or made of a mixture (alloy). For example, a wiring described as a copper wiring may be made of copper as an element or may have a composition which mainly contains copper and further contains other ingredients. In addition, for example, a pad connected to an external terminal may be made of aluminum as an element or may have a composition which mainly contains aluminum and further contains other ingredients. The copper wiring and the aluminum pad illustrated herein are examples and can be changed to be made of various metals. In addition, the wiring and the pad illustrated herein are examples of metallic members to be used in the photoelectric conversion apparatus and may also be applicable to other metallic members.

In the following explanation, it is assumed that an electric charge accumulated by a photoelectric conversion unit in a pixel is an electron. In addition, it is assumed that transistors included in pixels are all N-channel MOS transistors (hereinafter, abbreviated as NMOS transistors). However, the electric charge accumulated by the photoelectric conversion unit may be a hole, and in this case, the transistors in the pixels may be P-channel MOS transistors (hereinafter, abbreviated as PMOS transistors). In other words, a conductivity type of the transistor or the like can be appropriately changed according to a polarity of the electric charge which is treated as a signal.

In addition, in the following embodiments, connection between mutual elements in a circuit may be described. In this case, even when another element is present between the mutual elements of interest, the elements of interest are treated as being mutually connected unless otherwise specified. For example, it is assumed that an element A is connected to one node of a capacitor element C having a plurality of nodes, and an element B is connected to the other node. In such a case too, the element A and the element B are treated as being connected unless otherwise specified.

First Embodiment

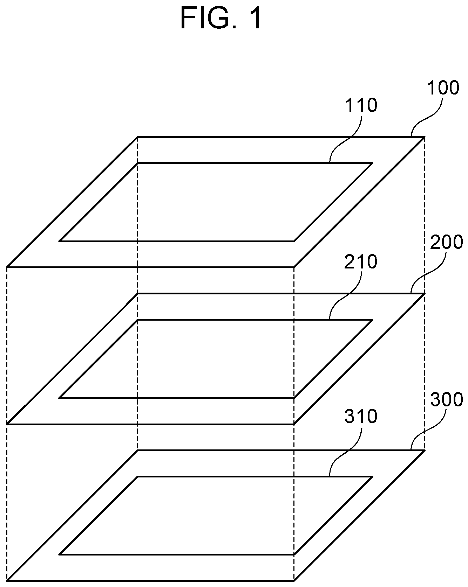

A photoelectric conversion apparatus according to a first embodiment based on the present disclosure will be described with reference to Fig. 1 to Fig. 10.

Fig. 1 illustrates an example of a block diagram for describing a photoelectric conversion apparatus according to the present embodiment.

As illustrated in Fig. 1, a photoelectric conversion apparatus 10 includes three substrates including a first substrate 100, a second substrate 200, and a third substrate 300. The photoelectric conversion apparatus 10 has a three-dimensional structure constituted by affixing these three substrates. In addition, the first substrate 100, the second substrate 200, and the third substrate 300 are laminated in this order. It is noted that even more substrates may be laminated. Hereinafter, a photoelectric conversion apparatus in which a plurality of substrates are laminated will be described as an example, but an apparatus with a configuration in which the first substrate 100, the second substrate 200, and the third substrate 300 are included in a single substrate is arranged may be used as the photoelectric conversion apparatus.

The first substrate 100 includes a pixel region 110 in which a plurality of pixels are arranged in a two-dimensional array in plan view. The second substrate 200 includes a memory region 210 in which a plurality of pixel memories are arranged in a two-dimensional array in plan view. In addition, the third substrate 300 includes a signal processing unit 310 in which a plurality of signal processing circuits are arranged.

It is noted that each of the first substrate 100, the second substrate 200, and the third substrate 300 may be a semiconductor layer such as a silicon substrate. In addition, each of the first substrate 100, the second substrate 200, and the third substrate 300 may include a semiconductor layer and a wiring structure. Each substrate may be a chip or may be a wafer. The photoelectric conversion apparatus 10 includes a plurality of metal bonding sections each of which is obtained by bonding a metal member of a top layer (first bonding layer) that is a wiring layer arranged on a side closest to the second substrate of the wiring structure of the first substrate and a metal member of a top layer (second bonding layer) that is a wiring layer arranged on a side closest to the first substrate of the wiring structure of the second substrate. In addition, a bonding surface provided with the plurality of metal bonding sections includes an insulating bonding section obtained by bonding an insulating member of the first bonding layer and an insulating member of the second bonding layer. In addition, the second substrate and the third substrate are bonded through a bonding structure similar to that of the first substrate and the second substrate. In this manner, since the metal members included in the respective substrates are mutually bonded, signals can be exchanged between the respective members.

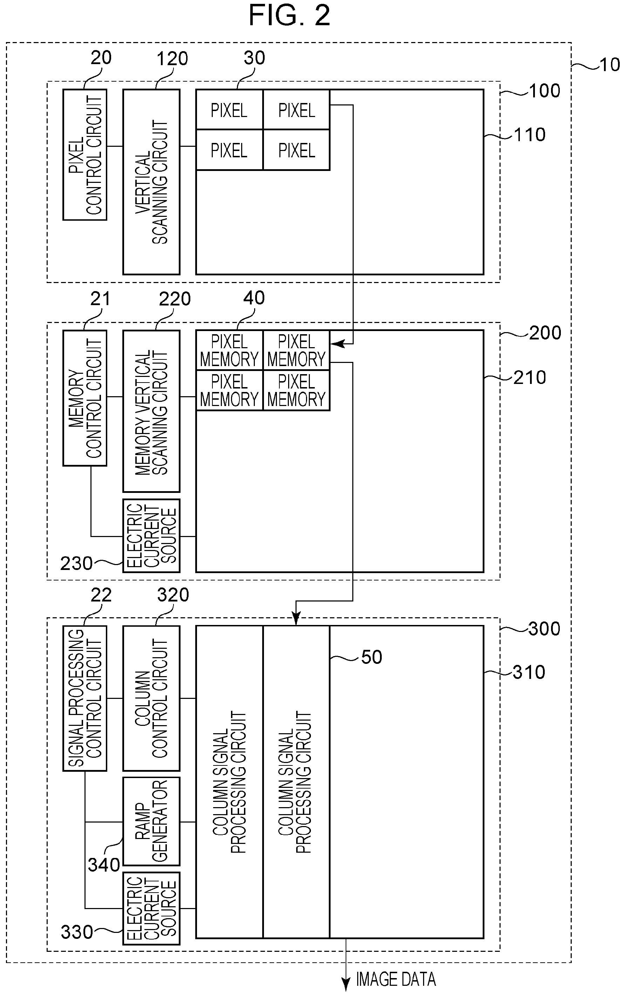

Fig. 2 is an example of a block diagram of the photoelectric conversion apparatus according to the present embodiment.

The first substrate 100 includes a pixel region 110, a vertical scanning circuit 120, and a pixel control circuit 20. The pixel region 110 includes a plurality of pixels 30 configured to perform photoelectric conversion. The plurality of pixels 30 are arranged in array across a plurality of rows and a plurality of columns in the pixel region 110. Each of the pixels 30 includes a photoelectric conversion element such as a photodiode. It is noted that the photoelectric conversion element may be a photoelectric conversion film. The photoelectric conversion element generates and accumulates a signal electric charge according to incident light. The pixel 30 outputs a pixel signal according to this signal electric charge amount. The pixel signal output from the pixel 30 is an analog signal.

It is noted that in the pixel region 110, in addition to an effective pixel configured to output a pixel signal according to a quantity of the incident light, an optical black pixel in which the photoelectric conversion element is light-shielded, a dummy pixel from which a signal is not output, and the like may be arranged. In addition, in the present specification, a horizontal direction in the drawing is described as a row direction, a vertical direction is described as a column direction, and the number of rows and the number of columns of a pixel array to be arranged in the pixel region 110 are not particularly limited.

The pixel control circuit 20 is a logic circuit configured to perform timing generation for causing the pixel 30 to operate and configured to output a drive pulse of the pixel 30 to the vertical scanning circuit 120. The vertical scanning circuit 120 includes a driver configured to drive the pixels 30 row by row. A voltage SVDD that is a power source voltage and SGND that is a reference voltage which are to be supplied to the pixel 30 may be supplied via a pad, a metal bonding section, or the like or may be supplied via the pixel control circuit 20.

The second substrate 200 includes a memory region 210, a memory vertical scanning circuit 220, an electric current source 230, and a memory control circuit 21. Pixel memories 40 are arranged across a plurality of rows and a plurality of columns in the memory region 210. Each of the pixel memories 40 has a function of holding the pixel signal output from the pixel 30. It is noted that the number of the pixels 30 included in the pixel region 110 and the number of the pixel memories 40 included in the memory region 210 do not need to be identical to each other. For example, the pixel memory 40 does not need to be arranged for a dummy pixel from which a signal is not output. In addition, a dummy pixel memory from which a signal is not output may be arranged corresponding to the dummy pixel.

The electric current source 230 supplies a reference electric current to the pixel memory 40. The memory control circuit 21 includes a logic circuit configured to perform timing generation for causing the pixel memory 40 to operate and configured to control a circuit arranged around the pixel such as the electric current source 230. A drive pulse output from the memory control circuit 21 is input to the memory vertical scanning circuit 220. The memory vertical scanning circuit 220 includes a driving driver configured to drive the pixel memories 40 row by row. A voltage MVDD that is a power source voltage and MGND (ground voltage) that is a reference voltage which are to be supplied to the pixel memory 40 may be supplied via a pad, a metal bonding section, or the like or may be supplied via the memory control circuit 21.

The third substrate 300 includes a signal processing unit 310, a column control circuit 320, a ramp generator 340, an electric current source 330, and a signal processing control circuit 22. In the signal processing unit 310, a column signal processing circuit 50 is arranged in array in the column direction. The column signal processing circuit 50 performs analog-to-digital (AD) conversion of the signal voltage output from the pixel memory 40 based on a reference voltage generated by the ramp generator 340. The column signal processing circuit 50 then outputs a signal after the AD conversion as image data to the outside of the third substrate 300. According to the present embodiment, the AD conversion of a ramp type will be described as an example of an AD conversion method. However, the AD conversion method is not limited to the AD conversion of the ramp type. For example, the AD conversion method can be AD conversion methods including AD conversion of a successive approximation type, AD conversion of a cyclic type, AD conversion of a ΔΣ type, and the like. In addition, the column signal processing circuit 50 may perform digital processing such as noise processing on image data.

The electric current source 330 supplies the reference electric current to the column signal processing circuit 50. The signal processing control circuit 22 includes a logic circuit configured to perform timing generation for causing the column signal processing circuit 50 to operate and function settings of the ramp generator 340 and the electric current source 330. The drive pulse output from the signal processing control circuit 22 is input to the column control circuit 320. The column control circuit 320 includes a driving driver configured to output a drive pulse to the column signal processing circuit 50. A voltage AVDD that is a power source voltage and AGND that is a reference voltage which are to be supplied to the column signal processing circuit 50 may be supplied via a pad, a metal bonding section, or the like or may be supplied via the signal processing control circuit 22.

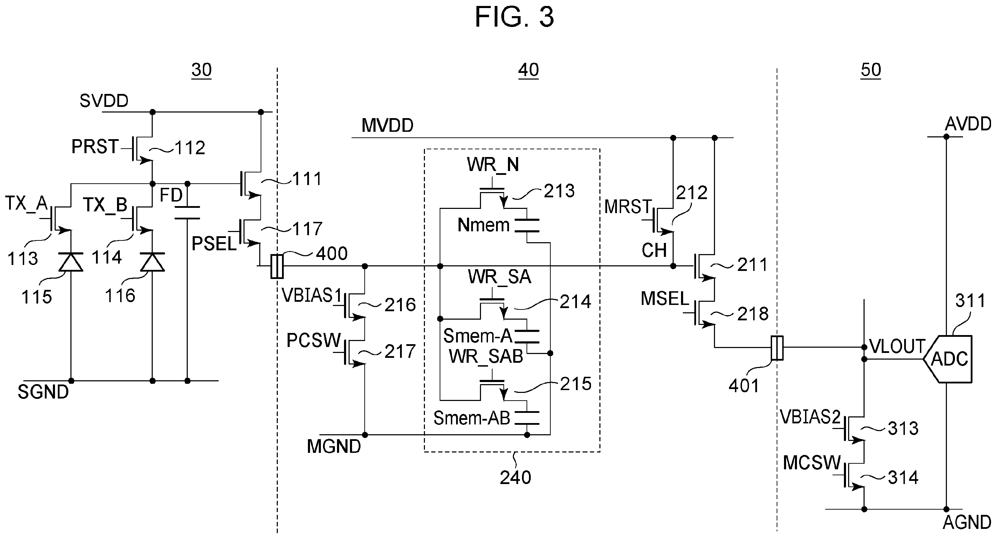

The photoelectric conversion apparatus according to the present embodiment is a photoelectric conversion apparatus configured to perform a global electronic shutter operation of a so-called voltage domain type. Readout of the pixel 30 in the photoelectric conversion apparatus according to the present embodiment will be described with reference to Fig. 3 to Fig. 5.

Fig. 3 is an example of a circuit diagram of the pixel 30, the pixel memory 40, and the column signal processing circuit 50 included in the photoelectric conversion apparatus according to the present embodiment.

The pixel 30 includes a photoelectric conversion element (PD) 115 and a PD 116, a transfer transistor 113 (pixel transfer transistor), a transfer transistor 114 (pixel transfer transistor), and a reset transistor 112 (pixel reset transistor). The pixel 30 further includes an amplification transistor 111 (first amplification unit, pixel amplification transistor), a selection transistor 117 (pixel selection transistor), and a floating diffusion capacitor unit (FD capacitor unit). The FD capacitor unit is an input node of the amplification transistor 111 serving as the first amplification unit. Signals from the PD 115 and the PD 116 are input to the amplification transistor 111. The amplification transistor 111 outputs a signal obtained by amplifying a signal level at this input node. It is noted that the "amplification" in the present specification includes a case where a gain is greater than or equal to 1 time and a case where the gain is less than 1 time. The amplification transistor 111 operates as a source follower circuit. Typically, an amplification factor of the amplification transistor 111 is within a range from 0.8 times to 1 time.

In the photoelectric conversion apparatus according to the present embodiment, the PD 115 and the PD 116 are included in a single pixel. The photoelectric conversion apparatus according to the present embodiment is a photoelectric conversion apparatus of so-called image plane phase difference detection in which signals of the PD 115 and the PD 116 are used for phase difference detection. An anode terminal of the PD 115 is connected to the reference power source SGND, and a cathode terminal is connected to a source of the transfer transistor 113. An anode terminal of the PD 116 is connected to the reference power source SGND, and a cathode terminal is connected to a source of the transfer transistor 114. Each of a drain of the pixel transfer transistor 113 and a drain of the pixel transfer transistor 114 is connected to a gate of the amplification transistor 111 and a source of the reset transistor 112. The FD capacitor unit is connected to the gate of the amplification transistor 111 while the reference power source SGND is used as a reference. The FD capacitor unit functions as a charge-voltage conversion unit configured to temporarily hold signal electric charges generated by the PD 115 and the PD 116 and convert the held signal electric charges into a voltage signal. A drain of the reset transistor 112 and a drain of the amplification transistor 111 are connected to a power source line of the voltage SVDD. A source of the amplification transistor 111 is connected to a drain of the selection transistor 117.

It is noted that the configuration of the pixel 30 illustrated in Fig. 3 is an example, and the pixel 30 may further include a transistor. For example, a transistor configured to change a capacitance value of the FD or a transistor configured to discharge the signal electric charge from the photoelectric conversion element 115 may be further provided. In addition, a configuration may be adopted in which the selection transistor 117 is not provided, and a selected or non-selected state of the pixel 30 is changed based on a voltage input from the reset transistor 112 to the FD.

The pixel memory 40 includes a holding capacitor unit 240. The holding capacitor unit 240 may be constituted by a plurality of capacitor elements and a plurality of write transistors. According to the present embodiment, the holding capacitor unit 240 includes a signal holding memory Nmem (first capacitor element), a signal holding memory Smem-A (second capacitor element), and a signal holding memory Smem-AB (third capacitor element) as a combination of the plurality of capacitor elements. Hereinafter, the plurality of signal holding memories may be collectively referred to as a signal holding memory mem (holding capacitor unit 240). The signal holding memory Nmem is connected to a memory write transistor 213, the signal holding memory Smem-A is connected to a memory write transistor 214, and the signal holding memory Smem-AB is connected to a memory write transistor 215. The pixel memory 40 is constituted by further including a memory reset transistor 212, an amplification transistor 211, an electric current source transistor 216 (first electric current source transistor), a switch transistor 217, and a selection transistor 218. The memory reset transistor 212 serves as a memory reset transistor, the amplification transistor 211 serves as a memory amplification transistor, and the selection transistor 218 serves as a memory selection transistor.

A source of the selection transistor 117 of the pixel 30 is connected to a drain of the electric current source transistor 216 of the pixel memory 40 via a metal bonding section 400. A source of the electric current source transistor 216 is connected to a drain of the switch transistor 217. At this time, a control signal VBIAS 1 is supplied to a gate of the electric current source transistor 216 from the electric current source 230 to perform control such that an electric current based on the control signal VBIAS1 flows. A configuration of the electric current source 230 will be described below.

A source of the selection transistor 218 is connected to a drain of an electric current source transistor 313 (second electric current source transistor) of the column signal processing circuit 50 via a metal bonding section 401. A source of the electric current source transistor 313 is connected to a drain of a switch transistor 314. At this time, a control signal VBIAS2 is supplied to the electric current source transistor 313 from the electric current source 330 to perform control such that an electric current based on the control signal VBIAS2 flows.

For the metal bonding sections 400 and 410, Cu to Cu bonding (CCB) can be used. Not only this, but as a method of electrically connecting the first substrate 100 and the second substrate 200 and electrically connecting the second substrate 200 and the third substrate 300, those substrates can be constituted by a through silicon via (TSV) or the like.

One terminal of the signal holding memory Nmem is connected to a power source line through which the reference power source MGND is supplied, and the other terminal is connected to a source of the memory write transistor 213. A drain of the memory write transistor 213 is connected to a gate of the amplification transistor 211 (second amplification unit). Similarly, one terminal of the signal holding memory Smem-A is connected to the power source line through which the reference power source MGND is supplied, and the other terminal is connected to a source of the memory write transistor 214. A drain of the memory write transistor 214 is connected to the gate of the amplification transistor 211. One terminal of the signal holding memory Smem-AB is connected to a power source line through which the reference power source MGND is supplied, and the other terminal is connected to a source of the memory write transistor 215. A drain of the memory write transistor 215 is connected to the gate of the amplification transistor 211. At this time, any element may be used as the signal holding memory (capacitor element) as long as the element has a function of holding a signal.

The capacitor element may be, for example, a capacitance formed in a wiring structure or may be a capacitance formed in a semiconductor layer such as a silicon substrate. The capacitance formed in the wiring structure is, for example, a dynamic random access memory (DRAM) or a metal-insulator-metal (MIM) capacitance structure formed in the wiring structure. In addition, the capacitance formed in the semiconductor substrate such as the silicon substrate is, for example, a metal-insulator-semiconductor (MIS) capacitance structure formed using polysilicon and a diffusion layer on the silicon substrate. The amplification transistor 211 operates as a source follower circuit. Typically, an amplification factor of the amplification transistor 211 is a range from 0.8 times to 1 time.

In addition, each of the memory write transistors 213, 214, and 215 is typically formed in a semiconductor substrate such as a silicon substrate. In a case where the signal holding memory (capacitor element) is formed of a DRAM included in the wiring structure, sources of the memory write transistors 213, 214, and 215 are connected to the DRAM via a contact plug and a wiring in the wiring structure.

The column signal processing circuit 50 is constituted by including an analog-to-digital converter (ADC) 311, the electric current source transistor 313, and the switch transistor 314.

The source of the electric current source transistor 313 is connected to the drain of the switch transistor 314, and a source of the switch transistor 314 is connected to a power source line through which the reference power source AGND is supplied. At this time, the control signal VBIAS2 is supplied to a gate of the electric current source transistor 313 from the electric current source 330, and the electric current based on the control signal VBIAS2 flows through the electric current source transistor 313. The drain of the electric current source transistor 313 is connected to an input of the ADC 311 via a signal line VLOUT, and the ADC 311 is connected to a power source line through the voltage AVDD is supplied and the power source line through which the reference power source AGND is supplied.

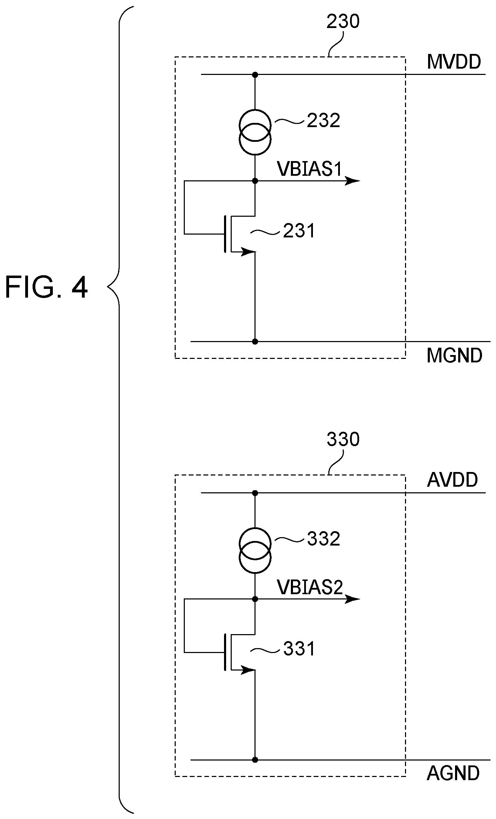

Here, Fig. 4 illustrates a configuration example of the electric current source 230 and the electric current source 330. In Fig. 4, the switch transistor 217 and the switch transistor 314 illustrated in Fig. 3 are omitted.

The electric current source 230 constitutes a current mirror circuit together with a reference electric current source 232 and a bias generation transistor 231. The reference electric current source 232 configured to generate a reference electric current is connected between a power source line through which the voltage MVDD is supplied and a drain of the bias generation transistor 231. A source of the bias generation transistor 231 is connected to the power source line through which the reference voltage AGND is supplied. Each of the pixel memories 40 is supplied with the control signal VBIAS1 generated by connecting a gate of the bias generation transistor 231 to the drain of the bias generation transistor 231.

The electric current source 330 constitutes a current mirror circuit together with a reference electric current source 332 and a bias generation transistor 331. The reference electric current source 332 configured to generate a reference electric current is connected between the power source line through which the voltage MVDD is supplied and a drain of the bias generation transistor 331. A source of the bias generation transistor 331 is connected to the power source line through which the reference voltage AGND is supplied. Each of the column signal processing circuits 50 is supplied with the control signal VBIAS2 generated by connecting a gate of the bias generation transistor 331 to the drain of the bias generation transistor 331.

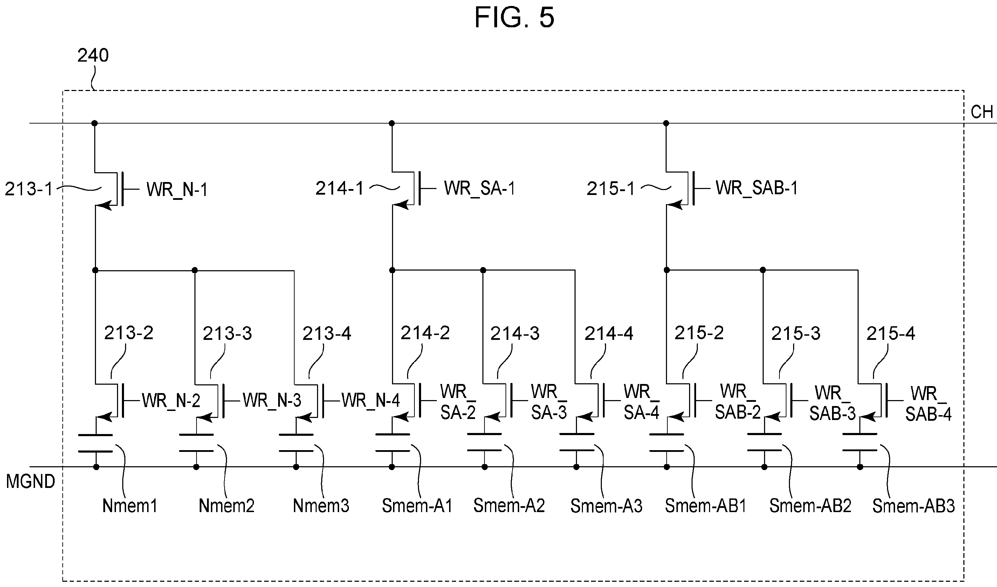

Fig. 5 illustrates a detailed configuration of the holding capacitor unit 240.

The signal holding memory Nmem of Fig. 3 is constituted by a plurality of signal holding memories Nmem1 to Nmem3 as illustrated in Fig. 5. The memory write transistor 213 is constituted by the memory write transistors 213-1 to 213-4. A source of the memory write transistor 213-1 is connected to drains of the memory write transistors 213-2 to 213-4. A drain of the memory write transistor 213-1 is connected to the gate of the amplification transistor 211. Terminals on one side of the plurality of signal holding memories Nmem1 to Nmem3 are connected to the power source line through which the reference power source MGND is supplied, and terminals on the other side are respectively connected to sources of the memory write transistors 213-2 to 213-4.

Similarly, the signal holding memory Smem-A is constituted by a plurality of signal holding memories Smem-A1 to Smem-A3. The memory write transistor 214 is constituted by memory write transistors 214-1 to 214-4. A source of the memory write transistor 214-1 is connected to drains of the memory write transistors 214-2 to 214-4. A drain of the memory write transistor 214-1 is connected to the gate of the amplification transistor 211. Terminals on one side of the plurality of signal holding memories Smem-A1 to Smem-A3 are connected to the power source line through which the reference power source MGND is supplied, and terminals on the other side are respectively connected to sources of the memory write transistors 214-2 to 214-4.

The signal holding memory Smem-AB is constituted by a plurality of signal holding memories Smem-AB1 to Smem-AB3. The memory write transistor 215 is constituted by memory write transistors 215-1 to 215-4. A source of the memory write transistor 215-1 is connected to drains of the memory write transistors 215-2 to 215-4. A drain of the memory write transistor 215-1 is connected to the gate of the amplification transistor 211. Terminals on one side of the plurality of signal holding memories Smem-AB1 to Smem-AB3 are connected to the power source line through which the reference power source MGND is supplied, and terminals on the other side are respectively connected to sources of the memory write transistors 215-2 to 215-4.

It is noted that connection relationships of the respective reference power sources are not limited to the configurations described in the present embodiment. For example, the reference power sources SGND and MGND may be common, the reference power sources MGND and AGND may be common. For the term "common" mentioned herein, it is possible to adopt a mode in which a single pad for connection to the outside of the photoelectric conversion apparatus is used in a plurality of reference power sources or a mode in which a common power source voltage is transmitted by connecting, to each other, two power source lines through which reference power sources are transmitted. In addition, the respective control circuits, scanning circuits, and substrates in which the electric current sources are arranged are not limited to the configurations described in the present embodiment. For example, the memory control circuit 21 and the electric current source 230 arranged in the second substrate may be arranged in the third substrate, or the electric current source 330 may be commonly used in the second substrate and the third substrate. Furthermore, a configuration may be adopted in which the second substrate and the third substrate are combined to be constituted by a single fourth substrate, and the first substrate and the fourth substrate may be laminated.

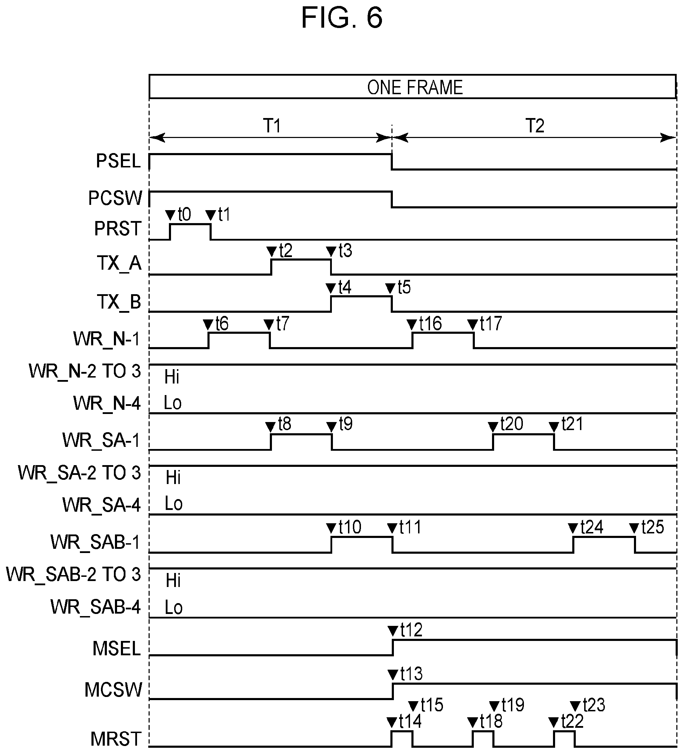

Fig. 6 is an example of a driving timing chart of the photoelectric conversion apparatus according to the present embodiment. In Fig. 6, a period T1 in which signal voltages based on the signal electric charges generated in the PD 115 and the PD 116 are held in the signal holding memories mem and a period T2 in which AD conversion of the signal voltages held in the signal holding memories mem is performed by the column signal processing circuit 50 will be described.

In Fig. 6, in a case where a control signal supplied from each of the control circuits is high, each of the transistors is configured to perform an ON operation (continuity), and in a case where the control signal is low, each of the transistors is configured to perform an OFF operation (non-continuity). It is noted that in Fig. 6, a level at high is denoted as Hi, and a level at low is denoted as Lo. This description manner is similar in the other drawings.

Relationships between the respective control signals and the transistors which operate based on the respective control signals illustrated in Fig. 6 will be described with reference to Fig. 3 and Fig. 5. In addition, the signal electric charges generated in the PD 115 and the PD 116 and the signal voltage held in the holding capacitor unit may be collectively referred to as a pixel signal.

During the period T1, control signals PSEL and PCSW turn to high, and the selection transistor 117 and the switch transistor 217 perform an ON operation. Thus, a state is established in which outputs from the PD 115 and the PD 116 can be supplied to a node CH (second input node) via a source follower (SF) circuit constituted by the electric current source transistor 216 and the amplification transistor 111 functioning as an amplification unit. First, during a period from a time t0 to a time t1, the control signal PRST turns to high, and the reset transistor 112 performs the ON operation, so that the FD capacitor unit is reset to an electric potential level based on the voltage SVDD. This is set as a first reset period.

After the first reset period is completed, during a period from a time t2 to a time t3, a control signal TX_A turns to high, and the transfer transistor 113 performs the ON operation. Thus, the signal electric charge generated based on the incident light by the photoelectric conversion element (PD 115) that is one of the plurality of photoelectric conversion elements is held in the FD capacitor unit. Thus, the signal electric charge of the PD 115 is supplied to the node CH via the SF circuit constituted by the amplification transistor 111 and the electric current source transistor 216. This is set as a first transfer period.

Similarly, during a period from a time t4 to a time t5, a control signal TX_B turns to high, and the transfer transistor 114 performs the ON operation. Thus, a signal electric charge obtained by adding up the respective signal electric charges generated based on the incident light by the one photoelectric conversion element and the other photoelectric conversion element (PD 116) of the plurality of photoelectric conversion elements is held in the FD capacitor unit. A signal corresponding to this added signal electric charge is supplied to the node CH via the SF circuit constituted by the amplification transistor 111 and the electric current source transistor 216. This is set as a second transfer period. It is noted that the period is not limited this mode, and between the time t3 and the time t4, the control signal PRST may turn to high again and then turn to low. In this case, similarly, during the period from the time t4 to the time t5, since the control signal TX_B turns to high, the signal electric charge generated based on the incident light by the PD 116 is held in the FD capacitor unit. A signal corresponding to this signal electric charge is supplied to the node CH via the SF circuit constituted by the amplification transistor 111 and the electric current source transistor 216.

Subsequently, control on the memory write transistors 213 to 215 and the voltage signal to be held in the signal holding memory mem will be described.

After the first reset period is ended, before the first transfer period is started, during a period from a time t6 to a time t7, an electric potential (hereinafter, which may be referred to as an N level) in a reset state of the FD capacitor unit is supplied to the node CH via the SF circuit constituted by the amplification transistor 111 and the electric current source transistor 216. This signal at the N level is a signal that mainly contains noise components. When a control signal WR_N-1 is set to high to cause the memory write transistor 213-1 to perform the ON operation at the time t6, the N level is sampled in the signal holding memory Nmem. Then, the control signal WR_N-1 is set to low to hold the N level at the time t7. In the example of Fig. 6, control signals WR_N-2 and WR_N-3 are set to high, and a control signals WR_N-4 is set to low, so that the N level is held in signal holding memories Nmem1 and Nmem2. In other words, during a period in which the signal holding memories Nmem1 and Nmem2 are selected, the signal holding memory Nmem3 is in the non-selected state.

At this time, the non-selected signal holding memory Nmem is supplied with a fixed electric potential. Specifically, both a first terminal and a second terminal of the non-selected signal holding memory Nmem are supplied with the fixed electric potential. By switching the control on the control signals WR_N-2 to WR_N-4, selection of the signal holding memories Nmem1 to Nmem3 can be switched. That is, a capacitance value of the signal holding memory Nmem can be adjusted to change the capacitance value.

A period from a time t8 to a time t9 is the first transfer period, and an electric potential (hereinafter, which may be referred to as an SA level) based on the signal electric charge of the PD 115 on the FD capacitor unit is supplied to the node CH via the SF circuit constituted by the amplification transistor 111 and the electric current source transistor 216. When a control signal WR_SA-1 is set to high to cause the memory write transistor 214-1 to perform the ON operation at the time t8, an SA level is sampled in the signal holding memory Smem-A. Then, the control signal WR_SA-1 is set to low to hold the SA level at the time t9. In the example of Fig. 6, control signals WR_SA-2 and WR_SA-3 are set to high, and a control signal WR_SA-4 is set to low, so that the SA level is held in the signal holding memories Smem-A1 and Smem-A2. By switching control on the control signals WR_SA-2 to WR_SA-4, selection of the signal holding memories Smem-A1 to Smem-A3 can be switched. That is, a capacitance value of the signal holding memory Smem-A can be adjusted to change the capacitance value.

Similarly, a period from a time t10 to a time t11 is the second transfer period, and an electric potential (hereinafter, which may be referred to as an SAB level) based on the signal electric charge of the PD 116 on the FD capacitor unit is supplied to the node CH via the SF circuit constituted by the amplification transistor 111 and the electric current source transistor 216. When a control signals WR_SAB-1 is set to high to cause the memory write transistor 215-1 to perform the ON operation at the time t10, the SAB level is sampled in the signal holding memory Smem-AB. Then, the control signal WR_SAB-1 is set to low to hold the SAB level at the time t11. In the example of Fig. 6, control signals WR_SAB-2 and WR_SAB-3 are set to high, and a control signal WR_SAB-4 is set to low, so that the SAB level is held in the signal holding memories Smem-AB 1 and Smem-AB2. By switching control on the control signals WR_SAB-2 to WR_SAB-4, selection of the signal holding memories Smem-AB 1 to Smem-AB3 can be switched. That is, a capacitance value of the signal holding memory Smem-AB can be adjusted to change the capacitance value. The capacitance value of each signal holding memory is preferably changed based on a range of a signal amplitude that the signal output by the pixel 30 may have.

Through these operations, the N level, the SA level, and the SAB level are held in the signal holding memory mem as the signal voltages. Herein, a period for sampling and holding the signal voltages in the signal holding memory mem is set as a voltage holding operation period.

A series of these operations from the start of the first reset period to the end of the second transfer period is set as a pixel signal voltage holding operation. By performing the pixel signal voltage holding operation in all the pixels at the same time, a global electronic shutter operation can be realized. The pixel signal voltage holding operation may be performed in all of the pixels 30 and all of the pixel memories 40 among the plurality of pixels 30 and the plurality of pixel memories 40, or the pixel signal voltage holding operation may be performed in some of the pixels 30 and some of the pixel memories 40. For example, the pixel signal voltage holding operation may be sequentially performed on a multiple pixel row basis or a multiple pixel column basis. In addition, the pixel signal voltage holding operation may be performed row by row.

After the pixel signal voltage holding operation, the signal voltage held in the signal holding memory mem is read out to the column signal processing circuit 50.

During the period T2 illustrated in Fig. 6, the selection transistor 117 performs the OFF operation. Thus, the pixel 30 and the pixel memory 40 are put into the non-connected state. In addition, since the switch transistor 217 performs the OFF operation, the electric current supplied by the electric current source transistor 216 is interrupted, so that the SF circuit constituted by the amplification transistor 111 and the electric current source transistor 216 is put into an inoperative state. Thus, the node CH becomes floating. At and after the time t11, a control signal MSEL turns to high to cause the selection transistor 218 to perform the ON operation at a time t12. In addition, at a time t13, a control signal MCSW turns to high to cause the switch transistor 314 to perform the ON operation. Thus, the node CH is in a state of being connected to the ADC 311 via the SF circuit constituted by the electric current source transistor 313 and the amplification transistor 211 which functions as the amplification unit configured to amplify the signal read out from the signal holding memory mem. Herein, the time t12 and the time t13 may be the same timing.

During a period from a time t14 to a time t15, a control signal MRST turns to high, and the memory reset transistor 212 performs the ON operation, so that the node CH is reset to an electric potential level based on the voltage MVDD. This is set as a second reset period.

After the second reset period, during a period from a time t16 to a time t17, the control signal WR_N-1 is set to high to cause the memory write transistor 213-1 to perform the ON operation, so that the signal voltages held in the signal holding memories Nmem1 and Nmem2 are output to the node CH. The ADC 311 performs AD conversion of the signal voltages read out via the SF circuit constituted by the amplification transistor 211 and the electric current source transistor 313 and held in the signal holding memories Nmem1 and Nmem2, that is, voltages based on the N level. This is set as a first AD conversion period.

An electric potential at the node CH is decided according to a capacitance of the node CH, wiring, diffusion capacitances of the memory write transistors 213-1, 214-1, and 215-1, a ratio of a capacitance value of a gate electrode or the like of the amplification transistor 211 to a capacitance value of the signal holding memory, and an electric potential difference between each node. For this reason, in the operation illustrated in Fig. 6, a configuration is adopted in which before the voltages held in the respective signal holding memories mem are read out, to reset the node CH to a fixed electric potential, the second reset period is prepared in which after the memory reset transistor 212 is caused to perform the ON operation, the OFF operation is performed.

After the first AD conversion period, between a time t18 and a time t19, the second reset period is prepared in which after the memory reset transistor 212 is caused to perform the ON operation, the OFF operation is performed.

After the second reset period from the time t18 to the time t19, during a period from a time t20 to a time t21, the control signal WR_SA-1 is set to high to cause the memory write transistor 214-1 to perform the ON operation. Thus, the signal voltages held in the signal holding memories Smem-A1 and Smem-A2 are output to the node CH. The ADC 311 performs AD conversion of the signal voltages read out via the SF circuit constituted by the amplification transistor 211 and the electric current source transistor 313 and held in the signal holding memories Smem-A1 and Smem-A2, that is, voltages based on the SA level. This is set as a second AD conversion period.

After the second AD conversion period, between a time t22 and a time t23, the second reset period is prepared in which after the memory reset transistor 212 is caused to perform the ON operation, the OFF operation is performed.

After the second reset period from the time t22 to the time t23, during a period from a time t24 to a time t25, the control signal WR_SAB-1 is set to high to cause the memory write transistor 215-1 to perform the ON operation. Thus, the signal voltages held in the signal holding memories Smem-AB 1 and Smem-AB2 are output to the node CH. The ADC 311 performs AD conversion of voltage signals read out via the SF circuit constituted by the amplification transistor 211 and the electric current source transistor 313 and held in the signal holding memories Smem-AB1 and Smem-AB2, that is, voltages based on the SAB level. This is set as a third AD conversion period.

After the third AD conversion period, the period T2 ends, and the selection transistor 218 and the switch transistor 314 perform the OFF operation. Thus, the pixel memory 40 and the column signal processing circuit 50 are put into the non-connected state. In addition, since the switch transistor 314 performs the OFF operation, the electric current supplied by the electric current source transistor 313 is interrupted, so that the SF circuit including the amplification transistor 211 and the electric current source transistor 313 is put into the inoperative state.

In the operation illustrated in Fig. 6, a reset operation of the PD 115, the PD 116 is not particularly specified, but for example, a time after the first transfer period and a time after the second transfer period may be set as an accumulation start time. In addition, during the period T2 or at a timing other than the periods T1 and T2, the transfer transistor 113, the transfer transistor 114, and the reset transistor 112 are caused to perform the ON operation. As a result, the PD 115 and the PD 116 may be reset to an electric potential based on the voltage SVDD. In addition, a configuration may be adopted in which separately from the reset transistor 112, a reset transistor may be provided between the PD 115 and the voltage SVDD and between the PD 116 and the voltage SVDD to perform the reset operation.

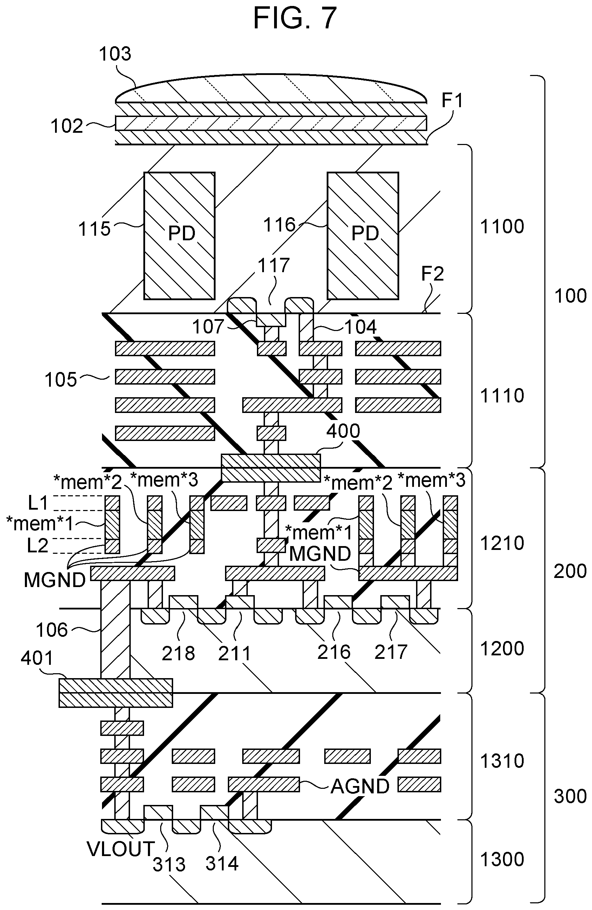

Fig. 7 illustrates a cross sectional structure including metal bonding sections of the first substrate 100, the second substrate 200, and the third substrate 300 according to the present embodiment. It is noted that Fig. 7 illustrates some elements and wiring connections among the components described in Fig. 3.

The first substrate 100 includes a semiconductor substrate 1100 (first semiconductor layer) and a wiring structure 1110 (first wiring structure). The semiconductor substrate 1100 is, for example, a silicon semiconductor substrate and serves as the first semiconductor layer in which the photoelectric conversion element and a readout circuit configured to read out a signal based on the photoelectric conversion of the photoelectric conversion element are formed. It is noted that in a case where instead of a photodiode, a photoelectric conversion film is used as the photoelectric conversion element, this photoelectric conversion film may be provided above the first semiconductor layer. It is noted that the semiconductor substrate 1100 may be formed of a material other than silicon and may be, for example, a compound semiconductor substrate such as a gallium arsenide substrate. Herein, the description will continue where the semiconductor substrate 1100 is a silicon single crystal substrate.

Fig. 7 describes the PD 115, the PD 116, and the selection transistor 117 as examples of the elements included in the semiconductor substrate 1100. A micro lens 103 and a color filter 102 are formed on a light incident surface side of the semiconductor substrate 1100. The color filter 102 has a function of restricting a wavelength range of the incident light. For example, light in a wavelength range corresponding to each of red, green, and blue colors of visible light can be transmitted therethrough.

The micro lens 103 has a function of focusing the incident light onto the PD 115 and the PD 116. A first main surface F1 of the semiconductor substrate 1100 is a surface where the incident light enters. In addition, a second main surface F2 of the semiconductor substrate 1100 is a surface provided with a gate of the transistor. The second main surface F2 is located between the first main surface F1 and the wiring structure 1110 of the first substrate 100 (first wiring structure).

A metal wiring 105 which connects each circuit is arranged in multiple layers in the wiring structure 1110. Contact vias 104 are provided for connecting each component between the metal wirings 105 in the respective layers, between the metal wiring 105 and the semiconductor substrate 1100, and between the metal wiring 105 and transistors formed in the semiconductor substrate 1100. For example, in the selection transistor 117, the contact via 104 is connected to a source region.

A gate electrode 107 is polysilicon forming a gate electrode of the transistor. The wiring structure 1110 is the first wiring structure in which each of the PD 115, the PD 116, the readout circuit included in the semiconductor substrate 1100, and the readout circuit included in the second substrate 200 is electrically connected.

The second substrate 200 includes a semiconductor substrate 1200 and a wiring structure 1210 of the second substrate 200 (second wiring structure). The semiconductor substrate 1200 is, for example, a silicon semiconductor substrate and serves as a second semiconductor layer including a memory and an output circuit configured to output a held voltage of the memory. It is noted that the semiconductor substrate 1200 may be formed of a material other than silicon and may be, for example, a compound semiconductor substrate such as a gallium arsenide substrate. Herein, the description will continue where the semiconductor substrate 1200 is a silicon single crystal substrate. As illustrated in Fig. 7, a thickness of the semiconductor substrate 1100 and a thickness of the semiconductor substrate 1200 may be different from each other or may be the same. When the thickness is different, for example, as illustrated in Fig. 7, the thickness of the semiconductor substrate 1100 may be smaller than the thickness of the semiconductor substrate 1200.

Fig. 7 illustrates the electric current source transistor 216, the switch transistor 217, the amplification transistor 211, and the selection transistor 218 as examples of the elements included in the semiconductor substrate 1200.

The wiring structure 1210 of the second substrate 200 is the wiring structure formed by the metal wiring 105, the contact via 104, and the gate electrode 107 similarly as in the wiring structure 1110 of the first substrate 100.

The signal holding memories Nmem1 to Nmem3, the signal holding memories Smem-A1 to Smem-A3, and the signal holding memories Smem-AB1 to Smem-AB3 described in Fig. 3 and Fig. 5 are formed in the wiring structure 1210.

In Fig. 7, the signal holding memories are respectively denoted as *mem*1 to 3, and represent a plurality of signal holding memories in which electrodes are respectively separated. The wiring structure 1210 electrically connects the signal holding memory mem and each of the output circuits. Herein, it is sufficient when the signal holding memory mem has a function of holding the signal voltage, and as described above, a configuration may be adopted in which a capacitor is formed in the semiconductor substrate 1200 to hold a signal. This configuration will be described below.

The third substrate 300 includes a semiconductor substrate 1300 and a wiring structure 1310 (third wiring structure). The semiconductor substrate 1300 is, for example, a silicon semiconductor substrate and is a third semiconductor layer including a second readout circuit configured to read out a signal according to the held voltage of the memory. Fig. 7 illustrates the electric current source transistor 313 and the switch transistor 314 as examples of the elements included in the semiconductor substrate 1300.

Similarly as in the wiring structure 1110, the wiring structure 1310 is the third wiring structure which is formed by the metal wiring 105, the contact via 104, and the gate electrode 107 and which is electrically connected to the second readout circuit.

As illustrated in Fig. 7, the wiring structure 1110 of the first substrate 100 and the wiring structure 1210 of the second substrate 200 are affixed so as to face each other to form the metal bonding section 400 in an electrically connected section. The metal bonding section 400 of Fig. 7 is CCB. The metal bonding section 400 is obtained by affixing a Cu pad (metal member) formed on a lower surface (first layer) of the wiring structure 1110 to a Cu pad (metal member) formed on an upper surface (second layer) of the wiring structure 1210 for connection. In addition, an insulating bonding section is formed in which an insulating member of the first layer and an insulating member of the second layer are bonded to each other.

Furthermore, the wiring structure 1210 of the second substrate 200 and the wiring structure 1310 of the third substrate 300 are connected via the semiconductor substrate 1200. A through silicon via (TSV) 106 is formed in the semiconductor substrate 1200 to be connected to a Cu pad prepared on a lower surface of the semiconductor substrate 1200. This Cu pad is bonded to a Cu pad formed on an upper surface of the wiring structure 1310 to form the metal bonding section 401 of CCB.

The selection transistor 117 is connected to the electric current source transistor 216 via the metal bonding section 400. In addition, the selection transistor 218 is connected to the column signal processing circuit 50 and the electric current source transistor 313 via the metal bonding section 401.

In Fig. 7, as described in Fig. 3 and Fig. 5, out of two terminals of the signal holding memory mem, one is connected to the memory write transistor, and the other is connected to the voltage MGND. In Fig. 7, a plurality of wiring patterns segmented by insulating members are included in a third layer L1. A portion (first capacitor portion) of the signal holding memory mem is included in the plurality of wiring patterns of the third layer L1, and the plurality of signal holding memories mem are respectively separated by the insulating members.

In Fig. 7, a plurality of wiring patterns segmented by insulating members are included in a fourth layer L2. A portion (second capacitor portion) of the signal holding memory mem is included in the plurality of wiring patterns of the fourth layer L2, and the plurality of signal holding memories mem are respectively separated by the insulating members. In Fig. 7, as described in Fig. 3, and Fig. 5, a configuration is adopted in which each of the second capacitor portions is connected to the power source line of the voltage MGND, but each may be connected to a power source line through which a different voltage is supplied.

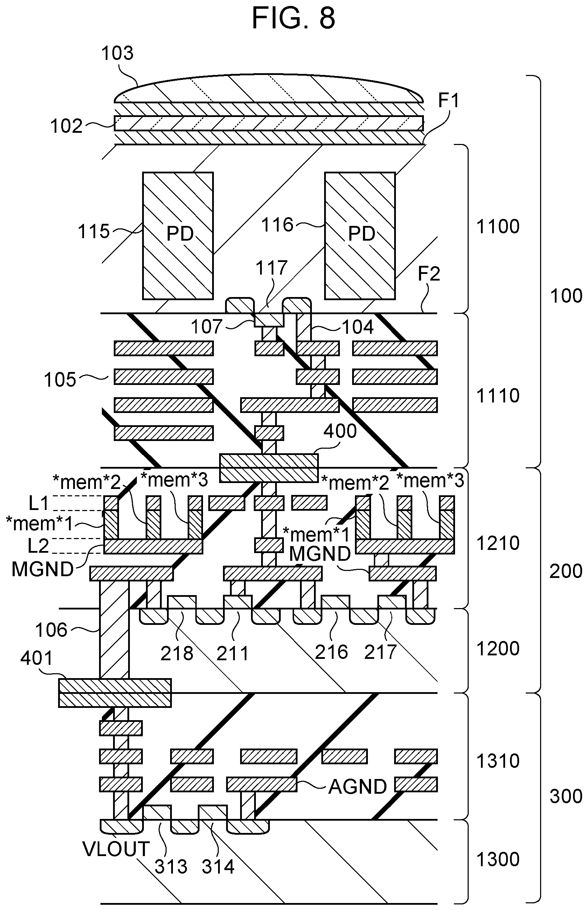

Fig. 8 is a schematic cross sectional view of the first substrate 100, the second substrate 200, and the third substrate 300 in an example different from Fig. 7.

Similarly as in the configuration in Fig. 7, the signal holding memories Nmem1 to Nmem3, the signal holding memories Smem-A1 to Smem-A3, and the signal holding memories Smem-AB1 to Smem-AB3 are formed in the wiring structure 1210. Similarly as in Fig. 7, the signal holding memories are respectively denoted as *mem*1 to 3. Fig. 8 is different from Fig. 7 in that an electrode connected to the power source line of the voltage MGND is common in the plurality of signal holding memories. In Fig. 8 too, similarly as in Fig. 7, a capacitance value of each signal holding memory mem can be changed. In addition, as in Fig. 8, by setting the capacitor portion to be common in the fourth layer L2, connection can be established to the same power source line between the signal holding memories at a low resistance. Thus, it is possible to reduce a variation in the voltage MGND serving as a voltage holding reference between the signal holding memories and increase a quality of the held signal.

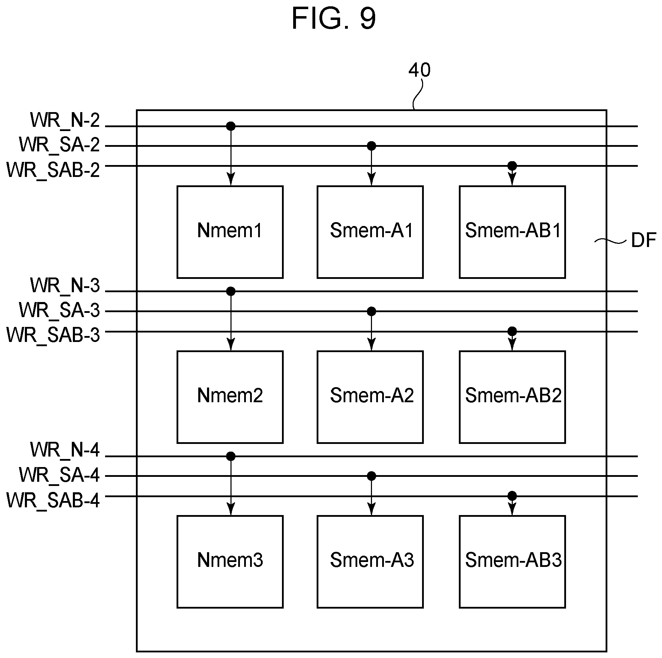

Fig. 9 is a schematic plan view regarding an arrangement of the signal holding memories Nmem1 to Nmem3, the signal holding memories Smem-A1 to Smem-A3, and the signal holding memories Smem-AB 1 to Smem-AB3 arranged in the wiring structure 1210 for the pixel memory 40. Fig. 9 is a view of the third layer L1 illustrated in Fig. 7 as a plan view relative to the semiconductor substrate 1100. It may be mentioned that Fig. 9 illustrates a plurality of wiring patterns in the third layer L1.

A connection relationship between the signal holding memory and the control signal is represented by an arrow, but this includes a write transistor, and each signal holding memory is controlled by each control signal. The control mentioned herein indicates, for example, controlling to one of selection and non-selection of the signal holding memory. It is noted that the control signals WR_N-1, WR_SA-1, and WR_SAB-1 for controlling the write transistors 213-1, 214-1, and 215-1 are omitted.

In the third layer L1, the plurality of wiring patterns are electrically separated by an insulating member DF. It is noted that a schematic plan view with regard to the fourth layer L2 can be considered to be similar to that of Fig. 9. In Fig. 9, the signal holding memories Nmem1 to Nmem3 are arranged in an up and down direction, the signal holding memories Smem-A1 to Smem-A3 are arranged in the up and down direction, the signal holding memories Smem-AB1 to Smem-AB3 are arranged in the up and down direction, respectively. In addition, with regard to control signal lines, an example is adopted in which control signals WR_N-2, WR_SA-2, and WR_SAB-2 are arranged to be adjacent to one another, control signals WR_N-3, WR_SA-3, and WR_SAB-3 are similarly arranged to be adjacent to one another, and control signals WR_N-4, WR_SA-4, and WR_SAB-4 are similarly arranged to be adjacent to one another. However, the configuration is not limited to this arrangement example.

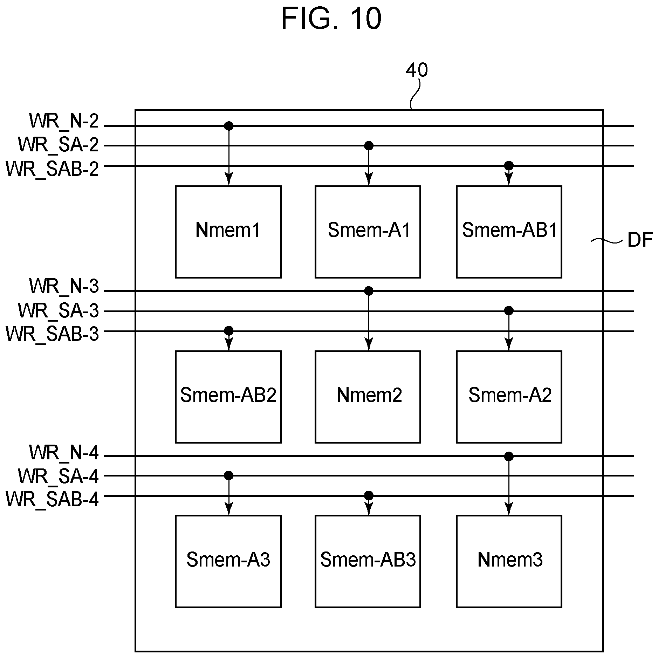

Fig. 10 is a schematic plan view regarding an arrangement of the signal holding memories Nmem1 to Nmem3, the signal holding memories Smem-A1 to Smem-A3, and the signal holding memories Smem-AB 1 to Smem-AB3 arranged in the wiring structure 1210 in an example different from Fig. 9 for the pixel memory 40. Each of the signal holding memories Nmem1 to Nmem3, the signal holding memories Smem-A1 to Smem-A3, and the signal holding memories Smem-AB1 to Smem-AB3 may be irregularly arranged. Fig. 10 is different from Fig. 9 in that the signal holding memories Nmem1 to Nmem3 are arranged to be adjacent to one another in a diagonal direction. Similarly, the signal holding memories Smem-A1 to Smem-A3 and the signal holding memories Smem-AB 1 to Smem-AB3 are also arranged in the diagonal direction, and the control signal lines are similarly arranged as in Fig. 9. As operation timings are described with reference to Fig. 6, the voltage signals at the N level, the SA level, and the SAB level are held in the signal holding memory Nmem, the signal holding memory Smem-A, and the signal holding memory Smem-AB through the sampling and holding operation. For example, a period from the time t6 to the time t7 (sampling period N) in which the N level is sampled in the signal holding memory Nmem is roughly decided by a drive force of the SF circuit constituted by the amplification transistor 111 and the electric current source transistor 216 and the capacitance value of the signal holding memory Nmem. The drive force of the SF circuit refers to, for example, an amount of an electric current caused by the electric current source transistor 216 to flow. It is noted that the amount of the electric current caused by the electric current source transistor 216 to flow can be set to be variable by adjusting a size of the bias generation transistor 231 described in Fig. 4 and adjusting a current mirror ratio. In addition, the amount of the electric current caused by the electric current source transistor 216 to flow can be set to be variable by adjusting an electric current of the reference electric current source 232. Furthermore, the amount of the electric current caused by the electric current source transistor 216 to flow can be set to be variable by changing a voltage to be applied to the gate of the electric current source transistor 216. The same also applies to a period from the time t8 to the time t9 (sampling period SA) in which the SA level is sampled in the signal holding memories Smem-A1 and Smem-A2. In addition, the same also applies to a period from the time t10 to the time t11 (sampling period SAB) in which the SAB level is sampled in the signal holding memories Smem-AB 1 and Smem-AB2.

As described in Fig. 6, one frame period is decided by the periods T1 and T2. In other words, to speed up a frame rate of the photoelectric conversion apparatus, at least one of the period T1 and the period T2 needs to be shortened. The period T1 is roughly decided by the sampling period N, the sampling period SA, and the sampling period SAB. For example, in a case where the period T1 is to be shortened, a drive force of the SF circuit constituted by the amplification transistor 111 and the electric current source transistor 216 needs to be increased. For example, an electric current caused to flow through the electric current source transistor 216 needs to be increased. In this case, an electric current needs to be increased in each pixel, which may increase electric power. On the other hand, by reducing the capacitance value of the signal holding memory mem, each of the sampling periods can be shortened to shorten the period T1. It is noted however that when the signal holding memory mem is reduced, a frequency band of noise may change. For example, noise performance may degrade, and a variation in an accuracy of an absolute value of the capacitance and a variation between capacitors may increase. An image quality and an image capturing performance may be degraded such as a decrease in an accuracy of the held voltage and a decrease in an accuracy of phase difference detection. In addition, to adjust the period T2, the drive power of the SF circuit constituted by the amplification transistor 211 and the electric current source transistor 313 can be changed according to the capacitance value of the signal holding memory mem, but similarly, the increase in the electric power may occur. In addition, when the number of column signal processing circuits 50 to be arranged is increased and the number of parallel signal processing operations is increased, the speed can be increased, but in this case, increases in the area and the electric power may occur.

According to the present embodiment, the capacitance value of the signal holding memory mem, a drive force of the amplification transistor 111, and a drive force of the amplification transistor 211 can be appropriately set. Therefore, in the photoelectric conversion apparatus provided with a global electronic shutter function of a voltage holding type, the capacitance value and the drive force of the SF circuit can be set by taking into account a size of the capacitor element, a signal settling time, and the like, and there is a possibility to further improve the image capturing performance.

In another aspect, in a case where durations of the sampling period N, the sampling period SA, and the sampling period SAB are lengthy, for example, a susceptibility to low frequency noise effects is increased. Alternatively, a holding period of the capacitor is lengthened, which may become a factor of the image quality degradation such as the decrease in the accuracy of the held voltage decreases due to a leak current of the signal holding memory. In other words, it can be mentioned that the increase in the duration of the period T1 largely affects the image quality performance. In addition, a degree of these effects differ depending on the capacitance value of the signal holding memory.

According to the present embodiment, as described in Fig. 5 and Fig. 6, a configuration is adopted in which the signal holding memory Nmem, the signal holding memory Smem-A, and the signal holding memory Smem-AB can select the capacitance value based on the control signals WR_N-2 to WR_N-4, WR_SA-2 to WR_SA-4, and WR_SAB-2 to WR_SAB-4. For example, when a readout speed is slow, and an image with a high image quality is to be obtained as in one-shot still image photography, the signal holding memories Nmem1 to Nmem3, the signal holding memories Smem-A1 to Smem-A3, and the signal holding memories Smem-AB 1 to Smem-AB3 are all selected. Thus, the noise is reduced, and the effects from the leakage are reduced. On the other hand, a configuration can be adopted in which the period T1 is lengthened by suppressing the drive force of the SF circuit constituted by the amplification transistor 111 and the electric current source transistor 216, but the increase in the electric power is suppressed. Alternatively, when the degradation in the image quality can be allowed in high frame rate movie shooting, the signal holding memory Nmem1, the signal holding memory Smem-A1, and the signal holding memory Smem-AB 1 are selected to allow the increase in the noise and the effects from the leakage. Furthermore, a configuration can be adopted in which the period T1 is shortened while the drive force of the SF circuit constituted by the amplification transistor 111 and the electric current source transistor 216 is increased to increase the electric power. It is noted that in this case, in the arrangement illustrated in Fig. 9, memories that are not physically adjacent between each memory like the signal holding memory Nmem1, the signal holding memory Smem-A2, and the signal holding memory Smem-AB3 may be selected. Thus, a configuration can be adopted to reduce crosstalk between the signal holding memories.

A gate width of the electric current source transistor 216 may be different from a gate width of the electric current source transistor 313. For example, the gate width of the electric current source transistor 216 may be larger than the gate width of the electric current source transistor 313. Thus, a drive force of the first amplification unit can be set to be larger than a drive force of the second amplification unit.

In accordance with the photoelectric conversion apparatus of the present embodiment, the number of signal holding memories to be selected, that is, the capacitance value can be selected to set the capacitance value to be variable. For example, the capacitance value of the holding capacitor unit 240 can be changed according to a change in an ON period of the memory write transistor. In addition, the drive force of the SF circuit constituted by the amplification transistor 111 and the electric current source transistor 216 can be adjusted. Similarly, the drive power of the SF circuit constituted by the amplification transistor 211 and the electric current source transistor 313 can be adjusted. The capacitance value of the holding capacitor unit 240 can be changed according to a change in the drive force of at least one of the drive force of the amplification transistor 111 and the drive force of the amplification transistor 211. Based on these, the capacitance value can be appropriately selected and adjusted according to the demanded image quality performance and image capturing performance.

It is noted that a configuration may be adopted in which according to the capacitance value of the signal holding memory mem, an operation of the memory reset transistor 212 may be adjusted or a size of the memory reset transistor 212 can be adopted. The size mentioned herein may be, for example, a gate width of the gate electrode or a gate length of the gate electrode. In a case where a configuration is adopted in which the signal holding memory mem is reset by the memory reset transistor 212, the reset period is adjusted or the size of the memory reset transistor 212 is switched according to the capacitance value of the signal holding memory mem. For example, in a case where the capacitance value of the signal holding memory mem is large, by lengthening the reset period or increasing the size of the memory reset transistor 212, a reset accuracy of the signal holding memory mem can be increased.

In another aspect, a configuration may be adopted in which in a case where any of the signal holding memories among the signal holding memories Nmem1 to Nmem3, the signal holding memories Smem-A1 to Smem-A3, and the signal holding memories Smem-AB1 to Smem-AB3 has a defect (defective characteristic or malfunction), the relevant memory is not to be used. For example, in the schematic plan view of the pixel memory 40 illustrated in Fig. 9, a configuration may be adopted in which the signal holding memory Smem-A2 of one pixel memory 40 has a defect, the signal holding memory Smem-A2 of the pixel memory 40 is not to be used. Thus, even when any of the signal holding memories has a defect, based on such control that the relevant signal holding memory is not to be used, it may be able to reduce the degradation in the image quality. In addition, a configuration may be adopted in which a spare signal holding memory is arranged, and in a case where one signal holding memory has a defect, connection is switched to the spare signal holding memory to be used.

It is noted that a layout relationship, an arrangement distance, shapes, and sizes of the signal holding memories mem are not limited to the configurations described in the present embodiment. For example, in part, as described in the present embodiment too, the sizes of the mutual signal holding memories mem may be the same or may be different. In addition, the shapes between the signal holding memories may be the same or may be different. The arrangement distances between the respective signal holding memories mem may be different.

In another aspect, a configuration may be adopted in which in a case where any of the signal holding memories among the signal holding memories Nmem1 to Nmem3, the signal holding memories Smem-A1 to Smem-A3, and the signal holding memories Smem-AB 1 to Smem-AB3 has a defect or a fault, the relevant signal holding memory is not to be used. Herein, the defect or the fault refers to a structural fault that may occur in manufacturing such as an open wiring, a short circuit, or a via formation fault for the signal holding memory, the memory write transistor, and the control signal line. Alternatively, a configuration may be adopted in which in a case where there is a characteristic variation such as a difference in the capacitance value or a difference in the leakage amount between the signal holding memories to such an extent that the variation affects the image quality, any of the signal holding memories is not to be used.

For example, a configuration may be adopted in which in a case where the signal holding memory Smem-A2 has a defect in the plan view of the pixel memory 40 in Fig. 9, the signal holding memories Smem-A2 are not to be used for the pixel memories 40 on the same row. For example, the capacitor element to be connected may be switched among the plurality of capacitor elements based on an inspection result of a signal output from the holding capacitor unit 240. Thus, even when any of the signal holding memories has a defect, by such control that the signal holding memories in the relevant row are not to be used, it may be able to reduce the degradation in the image quality. For example, a control line for controlling the holding capacitor unit 240 is provided, and the inspection result can be determined based on a signal difference between one end portion of the control line and the other end portion of the control line.

In addition, a determination unit configured to perform a determination based on the signal output from the holding capacitor unit 240 is provided, and the determination unit can determine the inspection result based on whether or not the signal output from the holding capacitor unit 240 is in a predetermined range. Then, in a case where the signal is in the predetermined range, some holding capacitor units 240 among the plurality of holding capacitor units 240 may be set to be non-selected.

Alternatively, in a case where the leakage amount of the signal holding memory Smem-A2 is larger than that of the other signal holding memory, the use or non-use may be switched according to a duration of the accumulation time which is, in general, highly relevant to the effects from the leakage, or the use or non-use may be switched according to a change in an ambient temperature. Based on these, even when there is a characteristic variation, it may be able to reduce the degradation in the image quality. It is noted that in the present embodiment, the pixel memory 40 has a configuration in which a drive driver is arranged for each row. For example, since the memory vertical scanning circuit 220 has a configuration in which the signal holding memory to be used can be selected for each row, it is possible to control the selection or non-selection of the signal holding memory for each row. In this case, the memory vertical scanning circuit 220 functions as a selection unit.

A configuration may also be adopted in which a spare signal holding memory is arranged, and in a case where one signal holding memory has a defect, switching is made to the spare signal holding memory to be used. In the plan view of the pixel memory 40 in Fig. 9, a configuration is adopted in which Nmem, Smem-A, and Smem-AB can be selected from three each for the signal holding memories mem. For example, while the use of the signal holding memories Nmem 1 and Nmem2 for the signal holding memories Nmem is set as a reference, the signal holding memory Nmem3 is set as a spare signal holding memory. A configuration may also be adopted to control the memory vertical scanning circuit 220 such that Nmem2 and Nmem3 are used in a case where the signal holding memory Nmem1 has a defect. Alternatively, in a case where the signal holding memories Nmem1 and Nmem2 have a defect and Smem-A1 to Smem-A3 do not have a defect, the signal holding memory Smem-A3 may be used as one of the signal holding memories Nmem.

Herein, two examples with regard to the inspection method of detecting the defect and the characteristic variation of the signal holding memory mem will be described.

As one inspection method, an operation (first operation) of writing a constant test voltage (predetermined voltage) to each signal holding memory mem is performed. Then, a signal is read out (second operation) from the signal holding memory mem to which the test voltage is written by the first operation. A third operation of inspecting the presence or absence of a defect of the photoelectric conversion apparatus based on the signal output from the photoelectric conversion apparatus by the second operation is performed.

Thus, the presence or absence of the defect of the photoelectric conversion apparatus can be confirmed. In this case, an output equivalent to each pixel output of the photoelectric conversion apparatus is an output based on the test voltage, and ideally, the outputs are uniform among the pixel memories 40 arranged in a matrix. For example, the output from the pixel memory 40 included in the pixel arranged in a first row and the output from the pixel memory 40 included in the pixel arranged in a second row which is different from the first row are compared. As an example of a determination of the detection, it is possible to determine the defect and the characteristic variation of each signal holding memory mem or each memory write transistor based on a deviation from an ideal value of each output or a comparison result between an average value of a plurality of particular outputs and each output. As another example of the detection determination, in a case where outputs in a specific row have an abnormality, it is possible to determine the presence or absence of an open wiring or a short circuit of the control signal common in the row.

A specific operation at the time of the inspection will be described with reference to Fig. 3 and Fig. 6. In Fig. 6, during the period T1, the control signals PSEL and PCSW are set to be low. Next, control signals WR_N, WR_SA, WR_SAB and the control signal MRST are set to high at the same time. Thereafter, by setting the control signals WR_N, WR_SA, and WR_SAB to be off, the signal holding memories Nmem, Smem-A, and Smem-AB of Fig. 3 hold a constant voltage based on the reference power source MVDD. During the period T2, it is sufficient to perform the control similarly as in Fig. 6. Herein, since each of the signal holding memories Nmem, Smem-A, and Smem-AB performs an output without an arithmetic operation in a digital signal processing unit which is not illustrated in the drawing, the inspection accuracy can be improved. It is noted that the voltage value of the reference power source MVDD may be set to be a variable voltage at the time of a detection operation. With this configuration, the defect depending on the pixel signal level from the pixel 30, that is, the defect with a dependency on the light amount may also be detected.

According to the inspection method described above, a fault of each signal holding memory mem, each memory write transistor, and furthermore, the line through which the control signal is supplied can be detected. According to the present embodiment, an example of being configured by a plurality of signal holding memories mem is adopted as illustrated in Fig. 5. In this case, the ON and OFF operations of only the control signals WR_N-1, WR_SA-1, and WR_SAB-1 are performed to hold and read out the voltage based on the reference power source MVDD in the signal holding memories Nmem1, Smem-A1, and Smem-AB1. Similarly, the ON and OFF operations of only the control signals WR_N-2, WR_SA-2, and WR_SAB-2 are performed to hold and read out the voltage based on the reference power source MVDD in the signal holding memories Nmem2, Smem-A2, and Smem-AB2. Furthermore, the ON and OFF operations of only the control signals WR_N-3, WR_SA-3, and WR_SAB-3 are performed to hold and read out the voltage based on the reference power source MVDD in the signal holding memories Nmem3, Smem-A3, and Smem-AB3. With this operation, the inspection of each signal holding memory mem, each write transistor, and the control signal can be performed.

In this mode, the constant test voltage is written to each signal holding memory mem, but the configuration is not limited to this mode. In other words, the inspection method using a plurality of test voltages (a plurality of predetermined voltages) with different voltage values may be adopted. According to this method, a first test voltage (voltage with a first voltage value) is written to some signal holding memories mem, and a second test voltage (voltage with a second voltage value) having a voltage value different from the first test voltage is written to some other signal holding memories mem. For example, the first test voltage is written to the signal holding memories mem of the pixels in odd-numbered rows, and the second test voltage is written to the signal holding memories mem of the pixels in even-numbered rows. In a case where the defect is absent, the first test voltage is read out from the signal holding memories mem of the pixels in the odd-numbered rows, and the second test voltage is read out from the signal holding memories mem of the pixels in the even-numbered rows. On the other hand, when a short circuit occurs in the signal holding memories mem of the pixels in the odd-numbered rows and the signal holding memories mem of the pixels in the even-numbered rows, the signals read out from the signal holding memories mem of the pixels in the odd-numbered rows and even-numbered rows has a voltage different from the first test voltage and the second test voltage. Thus, the detection on whether or not the short circuit occurs in the signal holding memory mem can be more appropriately performed.

In addition, with regard to the pixels in a plurality of rows, an arrangement of target pixels to which the first test voltage is to be written and an arrangement of target pixels to which the second test voltage is to be written may be varied. In other words, column locations of the pixels to which the first test voltage is to be written and column locations of the pixels to which the second test voltage is to be written may be varied in each pixel row. In accordance with such an arrangement, when the signals of the pixels in the plurality of rows are read out, it is possible to identify a normal pixel row and a pixel row in which an abnormality occurs. For this pixel row in which the abnormality occurs, it is possible to perform control to change the signal holding memory mem to be used.

In addition, as another inspection method, for example, there is a method of monitoring an input terminal of the memory region 210 of each control signal, that is, an output terminal of the drive driver for each row and an opposite side to the drive driver, that is, a termination of the signal line of the control signal. In a case where an electric potential difference or a phase difference is present at the input terminal or the termination of the signal line of the control signal, a fault on the control signal line may be detected. In this case, a configuration may be adopted in which the relevant drive driver is not to be used.

The two types of the inspection method have been described according to the present embodiment, but the defect and the characteristic variation may be the inspected by adopting an inspection method of a general semiconductor device. In addition, the determination of the inspection result may be determined based on an output of the photoelectric conversion apparatus or may be determined by a determination unit in the photoelectric conversion apparatus.

Second Embodiment

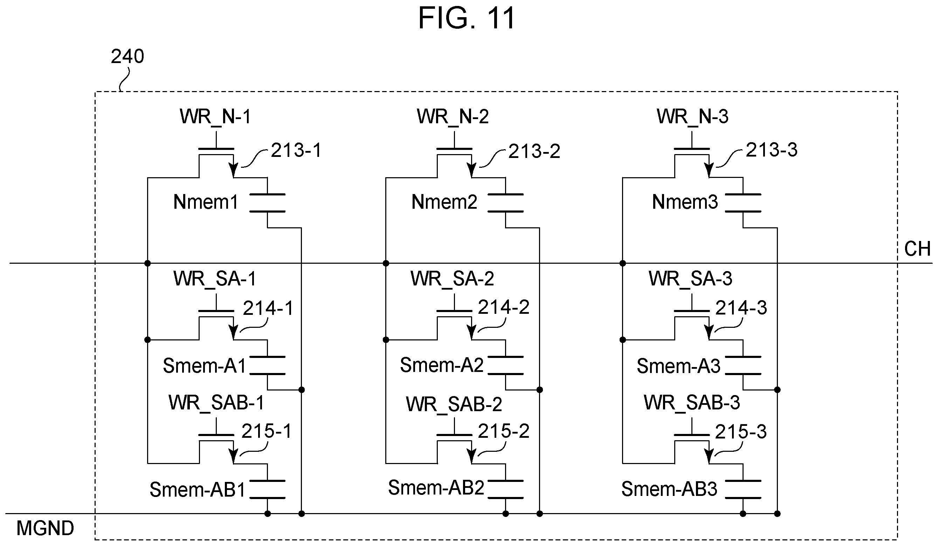

The photoelectric conversion apparatus according to a second embodiment based on the present disclosure will be described with reference to Fig. 11 to Fig. 13.

Fig. 11 is a circuit diagram of the signal holding memory (holding capacitor unit 240) of the photoelectric conversion apparatus according to the second embodiment. The same reference signs as those in Fig. 5 are allocated to the memory write transistors and the signal holding memories, but the configuration and the connection relationship of Fig. 5 are different from those of the first embodiment. Since substantially the same configuration as the first embodiment can be adopted except for this aspect and aspects described below, the description thereof may be omitted.

The signal holding memory Nmem is constituted by the plurality of signal holding memories Nmem1 to Nmem3. The memory write transistor 213 is constituted by the memory write transistors 213-1 to 213-3. Drains of the memory write transistors 213-1 to 213-3 are connected to the gate of the amplification transistor 211. Terminals on one side of the plurality of signal holding memories Nmem 1 to Nmem3 are connected to the power source line through which the reference voltage MGND is supplied, and terminals on the other side are respectively connected to sources of the memory write transistors 213-1 to 213-3. Similarly, the signal holding memory Smem-A is constituted by the plurality of signal holding memories Smem-A1 to Smem-A3. The memory write transistor 214 is constituted by the memory write transistors 214-1 to 214-3. Drains of the memory write transistors 214-1 to 214-3 are connected to the gate of the amplification transistor 211. Terminals on one side of the plurality of signal holding memories Smem-A1 to Smem-A3 are connected to the power source line through which the reference voltage MGND is supplied, and terminals on the other side are respectively connected to sources of the memory write transistors 214-1 to 214-3. The signal holding memory Smem-AB is constituted by the plurality of signal holding memories Smem-AB1 to Smem-AB3. The memory write transistor 215 is constituted by the memory write transistors 215-1 to 215-3. Drains of the memory write transistors 215-1 to 215-3 are connected to the gate of the amplification transistor 211. Terminals on one side of the plurality of signal holding memories Smem-AB1 to Smem-AB3 are connected to the power source line through which the reference voltage MGND is supplied, and terminals on the other side are respectively connected to sources of the memory write transistors 215-1 to 215-3.

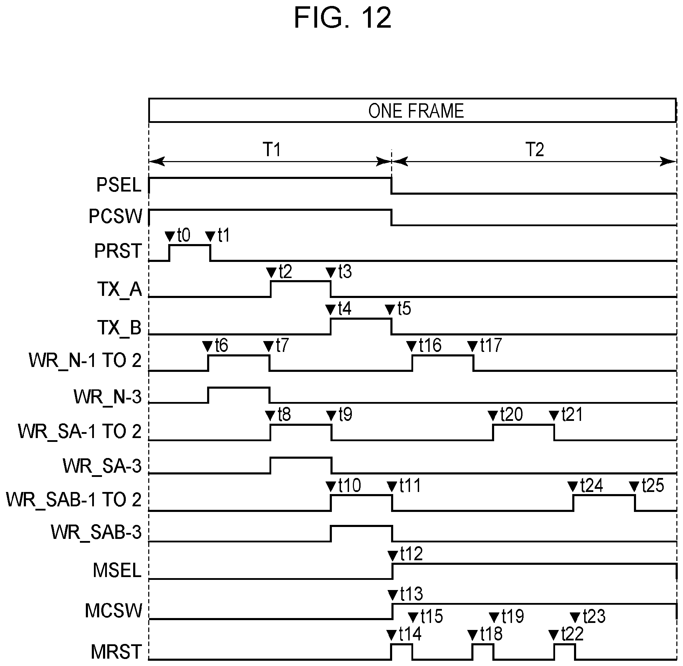

Fig. 12 is an example of a drive timing chart of the photoelectric conversion apparatus according to the present embodiment. In other words, Fig. 12 is an explanatory diagram for describing the operation timings of the readout circuits of Fig. 3 and Fig. 11. The description on aspects overlapping with the operations described in Fig. 6 will be omitted.

With regard to the operation timings in Fig. 12, during the sampling period N from the time t6 to the time t7, the control signals WR_N-1 to WR_N-3 are set to high to hold the N level in the signal holding memories Nmem1 to Nmem3.

On the other hand, during the period T2, the control signals WR_N-1 and WR_N-2 are set to high to read out the signal voltages held in the signal holding memories Nmem1 and Nmem2. Similarly, during the sampling period SA from the time t8 to the time t9, the control signals WR_SA-1 to WR_SA-3 are set to high to hold the SA level in the signal holding memories Smem-A1 to Smem-A3. On the other hand, during the period T2, the control signals WR_SA-1 and WR_SA-2 are set to high to read out the signal voltages held in the signal holding memories Smem-A1 and Smem-A2. During the sampling period SAB from the time t10 to the time t11, the control signals WR_SAB-1 to WR_SAB-3 are set to high to hold the SAB level in the signal holding memories Smem-AB1 to Smem-AB3. On the other hand, during the period T2, the control signals WR_SAB-1 and WR_SAB-2 are set to high to read out the signal voltages held in the signal holding memories Smem-AB 1 and Smem-AB2. In this manner, the capacitance value of the holding capacitor unit is changed according to a readout mode.

According to the present embodiment, when the output of the SF circuit constituted by the amplification transistor 111 and the electric current source transistor 216 is to be read out during the period T1, the signal holding memory that becomes a load capacitance of the SF circuit output is increased. In this manner, the capacitance value of the signal holding memory (holding capacitor unit 240) can be changed according to gain processing. Thus, high frequency components can be reduced with regard to the noise of the SF circuit. On the other hand, when the signal voltages held in the signal holding memories are to be read out during the period T2, the number of the signal holding memories is reduced from the number during the period T1. Thus, during the period T1, it may be possible to reduce effects from switching noise that may occur at the time of holding the signal voltage in each signal holding memory or switching noise that may occur at the time of selection during the period T2.

It is noted that in the configuration of Fig. 5 too, for example, during the period T1, the control signals WR_SA-2 to WR_SA-4 can be set to high to select the signal holding memories Smem-A1 to Smem-A3, and during the period T2, the control signal WR_SA-4 can be set to low to select the signal holding memories Smem-A1 and Smem-A2 for the readout. It is noted however that from the period T1 to the period T2, since the switching noise is superimposed due to the switching of the control signal WR_SA-4 from high to low, the image quality may degrade, and therefore the configuration illustrated in Fig. 11 is preferably adopted. It is noted that as described in Fig. 6, when each signal holding memory is read out during the period T2, the electric potential at the node CH changes depending on the capacitance value of the signal holding memory. Therefore, a configuration may be adopted in which the signal holding memory is selected to adjust the electric potential at the node CH.

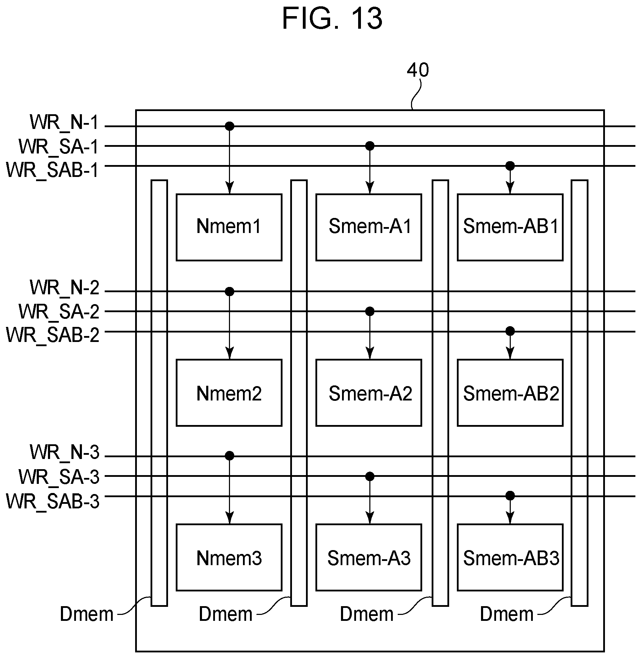

Fig. 13 is an example of a schematic plan view of the holding capacitor unit 240 of Fig. 11 for the pixel memory 40. In Fig. 13, a capacitor element Dmem that is a dummy and is not illustrated in Fig. 11 is arranged between the signal holding memories Nmem and Smem-A, between the signal holding memories Smem-A and Smem-AB, and between the pixel memories 40.

As illustrated in Fig. 3 and Fig. 6, holding operations of the voltage signals at the N level, the SA level, and the SAB level are respectively performed in different times in the signal holding memory Nmem, the signal holding memory Smem-A, and the signal holding memory Smem-AB to perform readout operations. For example, when a parasitic capacitance is present between the signal holding memories mem, a voltage signal held by crosstalk between each signal holding memory mem changes. For example, the capacitance value of the signal holding memory Nmem is denoted as CN, the capacitance value of the signal holding memory Smem-A is denoted as CA, the capacitance value of the signal holding memory Smem-AB is denoted as CAB, and it is assumed that a parasitic capacitance Cp is present between each of the signal holding memories. As described in Fig. 6, during the period from the time t10 to the time t11, in a case where a voltage on the signal holding memory Smem-AB changes by ΔV, a voltage change as represented by Expression (1) occurs in the signal holding memory Nmem, and a voltage change as represented by Expression (2) occurs in the signal holding memory Smem-A.

$$\Delta V \times Cp/(Cp + CN) \cdots (1)$$

$$\Delta V \times Cp/(Cp + CA) \cdots (2)$$

Furthermore, during the period T2, when the voltage signal of each signal holding memory mem is read out to the column signal processing circuit 50, the voltage on each signal holding memory mem changes according to a reset level at the node CH. Thus, the crosstalk occurs due to the parasitic capacitance Cp between each signal holding memory mem. Similarly, when a parasitic capacitance is present between the plurality of pixel memories 40, the crosstalk occurs between the pixel memories 40 too. These may become error factors for the signal electric charges generated in the PD 115 and the PD 116. For example, the crosstalk may cause an linearity error or an offset error of the pixel output signal for incident light. In addition, the crosstalk between the signal holding memory Smem-A and the signal holding memory Smem-AB may cause a phase difference detection error. Furthermore, the crosstalk between the pixels becomes so-called color mixture between the pixels of different colors to reduce the image quality.

In the present embodiment too, similarly as in the first embodiment, the capacitance value and the drive force of the SF circuit can be appropriately selected and adjusted according to the demanded image quality performance and image capturing performance. In addition, as illustrated in Fig. 13, by arranging the capacitor element Dmem that is a dummy, the crosstalk between the signal holding memories can be reduced.

It is noted that the capacitor element Dmem may be connected to a power source line through which a power source voltage VDD, a reference voltage GND, or the other reference voltage is supplied. In addition, a configuration may be adopted in which the capacitor element Dmem can be connected to the write transistor to be used as the signal holding memory.

Third Embodiment

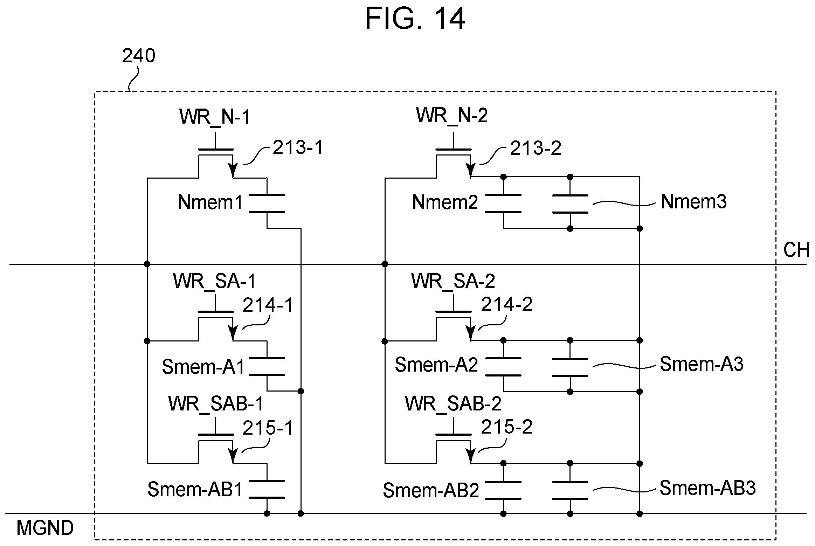

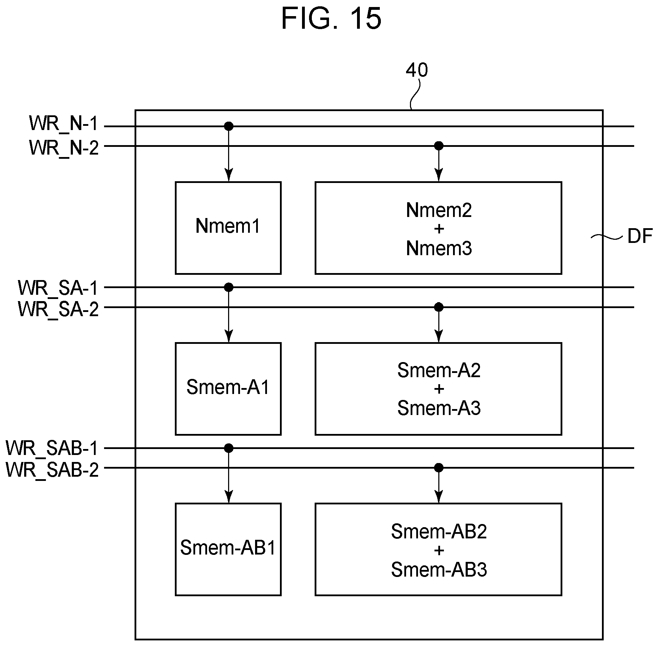

The photoelectric conversion apparatus according to a third embodiment based on the present disclosure will be described with reference to Fig. 14 and Fig. 15.

Fig. 14 is a circuit diagram of the signal holding memory (holding capacitor unit 240) of the photoelectric conversion apparatus according to the third embodiment. The same reference signs as those in Fig. 5 are allocated to the memory write transistors and the signal holding memories, but the number of memory write transistors and the connection relationship of Fig. 5 are different from those of the first embodiment and the second embodiment. Since substantially the same configuration as the first embodiment can be adopted except for this aspect and aspects described below, the description thereof may be omitted.

The signal holding memory Nmem is constituted by the plurality of signal holding memories Nmem1 to Nmem3. The memory write transistor 213 is constituted by the memory write transistors 213-1 and 213-2.

Drains of the memory write transistors 213-1 and 213-2 are connected to the gate of the amplification transistor 211. Terminals on one side of the plurality of signal holding memories Nmem 1 to Nmem3 are connected to the power source line through which the reference voltage MGND is supplied. A terminal on the other side of the signal holding memory Nmem1 is connected to the source of the memory write transistor 213-1, and terminals on the other side of the signal holding memories Nmem2 to Nmem3 are connected to a source of the memory write transistor 213-2.

The signal holding memory Smem-A is constituted by the plurality of signal holding memories Smem-A1 to Smem-A3. The memory write transistor 214 is constituted by the memory write transistors 214-1 and 214-2. Drains of the memory write transistors 214-1 and 214-2 are connected to the gate of the amplification transistor 211. Terminals on one side of the plurality of signal holding memories Smem-A1 to Smem-A3 are connected to the power source line through which the reference voltage MGND is supplied. A terminal on the other side of the signal holding memory Smem-A1 is connected to the source of the memory write transistor 214-1, and terminals on the other side of the signal holding memories Smem-A2 and Smem-A3 are connected to the memory write transistor 214-2.

The signal holding memory Smem-AB is constituted by the plurality of signal holding memories Smem-AB1 to Smem-AB3. The memory write transistor 215 is constituted by the memory write transistors 215-1 and 215-2. Drains of the memory write transistors 215-1 and 215-2 are connected to the gate of the amplification transistor 211. Terminals on one side of the plurality of signal holding memories Smem-AB 1 to Smem-AB3 are connected to the power source line through which the reference voltage MGND is supplied. A terminal on the other side of the signal holding memory Smem-AB1 is connected to the source of the memory write transistor 215-1, and terminals on the other side of the signal holding memories Smem-AB2 and Smem-AB3 are connected to a source of the memory write transistor 215-2.

According to the present embodiment, the capacitance value the signal holding memory mem selected by the write transistors 213-1, 214-1, and 215-1 is explicitly different from the capacitance value of the signal holding memory mem selected by the write transistors 213-2, 214-2, and 215-2. In Fig. 14, a difference of the capacitance values is illustrated by connecting the signal holding memories Nmem 2 and Nmem3, the signal holding memories Smem-A2 and Smem-A3, and the signal holding memories Smem-AB2 and Smem-AB3 in parallel. For this, a configuration may also be adopted in which a single signal holding memory with a different capacitance value is arranged.

In the present embodiment too, a configuration may be adopted in which a capacitor of any size can be selected according to the image quality performance and the image capturing performance as described in Fig. 6, or the control of the write transistor may be switched during the periods T1 and T2 as described in Fig. 12.

Fig. 15 is a plan view of the configuration of the pixel memory 40 in Fig. 14. Fig. 14 is a circuit diagram in which the signal holding memories Nmem 2 and Nmem3, the signal holding memories Smem-A2 and Smem-A3, and the signal holding memories Smem-AB2 and Smem-AB3 are arranged in parallel. It is noted however that since those memories are substantially treated as the single signal holding memory, in Fig. 15, those memories are illustrated as the single signal holding memory.

In the present embodiment too, similarly as in the first embodiment, the capacitance value and the drive force of the SF circuit can be appropriately selected and adjusted according to the demanded image quality performance and image capturing performance.

Fourth Embodiment

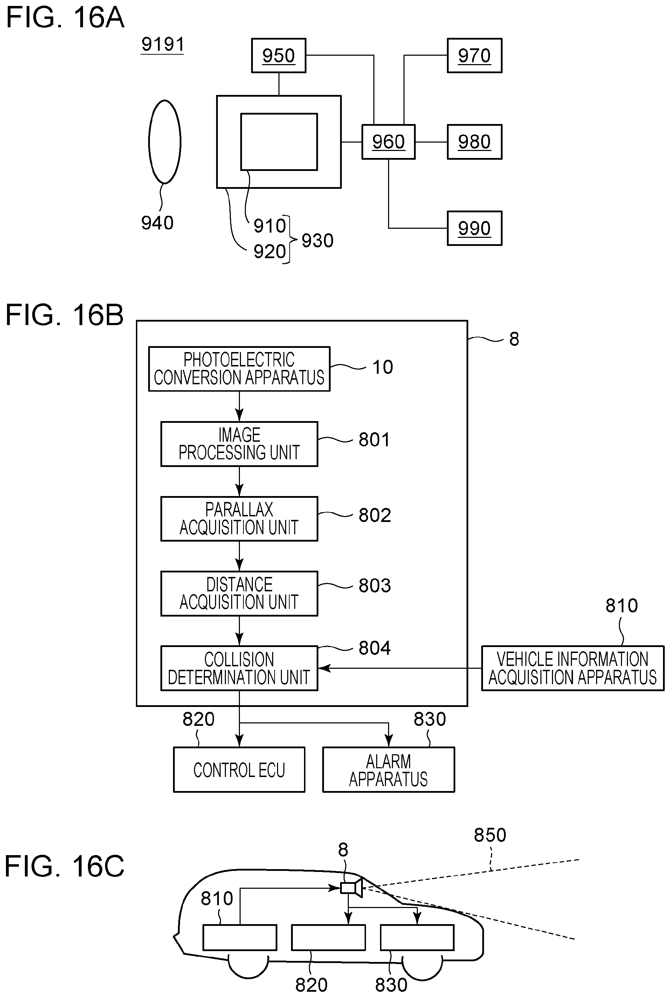

A fourth embodiment can be applied to the first embodiment to the third embodiment. Fig. 16A is a schematic diagram for describing an equipment 9191 including a semiconductor apparatus 930 according to the present embodiment. The photoelectric conversion apparatus according to each of the above-described embodiments can be used as the semiconductor apparatus 930. The equipment 9191 including the semiconductor apparatus 930 will be described in detail. The semiconductor apparatus 930 can include a semiconductor device 910. The semiconductor apparatus 930 can include, in addition to the semiconductor device 910, a package 920 that accommodates the semiconductor device 910. The package 920 can include a base to which the semiconductor device 910 is fixed and a lid such as glass facing the semiconductor device 910. The package 920 can further include a bonding member such as a bonding wire or a bump that connects a terminal included in the base and a terminal included in the semiconductor device 910.

The equipment 9191 may include at least any of an optical apparatus 940, a control apparatus 950, a processing apparatus 960, a display apparatus 970, a storage device 980, and a mechanical apparatus 990. The optical apparatus 940 corresponds to the semiconductor apparatus 930. The optical apparatus 940 is, for example, a lens, a shutter, or a mirror and includes an optical system configured to guide light to the semiconductor apparatus 930. The control apparatus 950 controls the semiconductor apparatus 930. The control apparatus 950 is, for example, a semiconductor apparatus such as an application specific integrated circuit (ASIC).

The processing apparatus 960 processes a signal output from the semiconductor apparatus 930. The processing apparatus 960 is a semiconductor apparatus such as a central processing unit (CPU) or an ASIC that constitutes an analog front end (AFE) or a digital front end (DFE). The display apparatus 970 is an electroluminescence (EL) display apparatus or a liquid crystal display apparatus configured to display information (image) acquired by the semiconductor apparatus 930. The storage device 980 is a magnetic device or a semiconductor device configured to store the information (image) acquired by the semiconductor apparatus 930. The storage device 980 is a volatile memory such as a static random access memory (SRAM) or a dynamic random access memory (DRAM), or a non-volatile memory such as a flash memory or a hard disk drive.

The mechanical apparatus 990 includes a movable part or a propulsive part such as a motor or an engine. In the equipment 9191, the signal output from the semiconductor apparatus 930 is displayed on the display apparatus 970 or transmitted to the outside by a communication apparatus (not illustrated) included in the equipment 9191. For this reason, the equipment 9191 may preferably further include the storage device 980 or the processing apparatus 960 in addition to a memory circuit or a calculation circuit included in the semiconductor apparatus 930. The mechanical apparatus 990 may be controlled based on the signal output from the semiconductor apparatus 930.

The equipment 9191 is also preferably used as electronic equipment such as an information terminal (for example, a smartphone or a wearable terminal) having an image capturing function or a camera (for example, a lens interchangeable type camera, a compact camera, a video camera, or a monitoring camera). The mechanical apparatus 990 in the camera can drive parts of the optical apparatus 940 for zooming, focusing, and a shutter operation. Alternatively, the mechanical apparatus 990 in the camera can move the semiconductor apparatus 930 for an image stabilization operation.

In addition, the equipment 9191 may be transportation equipment such as a vehicle, a ship, or a flying object. The mechanical apparatus 990 in the transportation equipment may be used as a transportation apparatus. The equipment 9191 serving as the transportation equipment may be preferably used as a component configured to transport the semiconductor apparatus 930 or a component configured to assist and/or automate driving (piloting) by the image capturing function. The processing apparatus 960 configured to assist and/or automate driving (piloting) can perform processing to operate the mechanical apparatus 990 serving as the transportation apparatus based on the information acquired by the semiconductor apparatus 930. Alternatively, the equipment 9191 may be medical equipment such as an endoscope, measuring equipment such as a ranging sensor, analytical equipment such as an electron microscope, office equipment such as a copier, or industrial equipment such as a robot.

According to the above-described embodiments, it becomes possible to attain a satisfactory pixel characteristic. Therefore, a value of the semiconductor apparatus can be increased. For the increase in the value mentioned herein, at least any of an addition of a function, an improvement of a performance, an improvement of a characteristic, an improvement of a reliability, an improvement of a manufacturing yield, a reduction of an environmental impact, a cost reduction, downsizing, and a weight reduction applies.

Therefore, when the semiconductor apparatus 930 according to the present embodiment is used as the equipment 9191, the value of the equipment can also be improved. For example, by mounting the semiconductor apparatus 930 to the transportation equipment, it is possible to attain an excellent performance when an image of an outside of the transportation equipment is captured or an external environment is measured. Thus, when the transportation equipment is to be manufactured and to be on sale, a decision of mounting the semiconductor apparatus according to the present embodiment to the transportation equipment is advantageous in an improvement of the performance of the transportation equipment itself. In particular, the semiconductor apparatus 930 is preferably used as the transportation equipment configured to perform driving assistance and/or automated driving of the transportation equipment by using the information acquired by the above-described semiconductor apparatus.

In addition, a photoelectric conversion system of the present embodiment and a movable object of the present embodiment will be described with reference to Figs. 16B and 16C.

Fig. 16B illustrates an example of a photoelectric conversion system related to an on-vehicle camera. A photoelectric conversion system 8 includes a photoelectric conversion apparatus 1. The photoelectric conversion apparatus 1 is the photoelectric conversion apparatus (image capturing apparatus) described in any of the above-described embodiments. The photoelectric conversion system 8 includes an image processing unit 801 configured to perform image processing on a plurality of pieces of image data acquired by the photoelectric conversion apparatus 1 and a parallax acquisition unit 802 configured to calculate a parallax (phase difference of parallax images) from a plurality of pieces of image data acquired by the photoelectric conversion system 8. Herein, the photoelectric conversion system 8 may also include, for example, an optical system which is not illustrated in the drawing and configured to guide light to the photoelectric conversion apparatus 10 such as a lens, a shutter, or a mirror. In addition, a plurality of photoelectric conversion units that are substantially conjugate with a pupil of the optical system may be arranged for pixels included in the photoelectric conversion apparatus 10. For example, the plurality of photoelectric conversion units that are substantially conjugate with the pupil are arranged so as to correspond to a single microlens. When the plurality of photoelectric conversion units receive light beams that have transmitted through mutually different positions of the pupil of the optical system, the photoelectric conversion apparatus 10 outputs image data corresponding to the light beams that have transmitted through the different positions. Then, the parallax acquisition unit 802 may calculate the parallax by using the output image data. In addition, the photoelectric conversion system 8 includes a distance acquisition unit 803 configured to calculate a distance to a target object based on the calculated parallax and a collision determination unit 804 configured to determine whether or not there is a possibility of collision based on the calculated distance. Herein, the parallax acquisition unit 802 and the distance acquisition unit 803 are examples of a distance information acquisition unit configured to acquire distance information of a distance to the target object. That is, the distance information refers to information related to a parallax, a defocus amount, a distance to the target object, or the like. The collision determination unit 804 may determine the possibility of collision by using any of these pieces of distance information. It is noted that the distance information may be acquired based on time of flight (ToF). The distance information acquisition unit may be realized by specifically designed hardware or may be realized by a software module. In addition, the distance information acquisition unit may be realized by a field programmable gate array (FPGA), an application specific integrated circuit (ASIC), or the like or may be realized by a combination of these components.

The photoelectric conversion system 8 is connected to a vehicle information acquisition apparatus 810 and can acquire vehicle information such as a vehicle speed, a yaw rate, or a steering angle. In addition, a control electronic control unit (ECU) 820 serving as a control apparatus configured to output a control signal for generating a braking force for the vehicle based on a determination result in the collision determination unit 804 is connected to the photoelectric conversion system 8. In addition, an alarm apparatus 830 configured to issue an alarm to a driver based on the determination result in the collision determination unit 804 is connected to the photoelectric conversion system 8. For example, in a case where the possibility of collision is high as the determination result of the collision determination unit 804, the control ECU 820 performs vehicle control to avoid a collision or mitigate damage by applying a brake, releasing an accelerator, reducing an engine output, or the like. The alarm apparatus 830 warns a user by sounding an alarm such as a sound, displaying alarm information on a screen such as a car navigation system, applying vibration to a seat belt or a steering wheel, or the like.

According to the present embodiment, an image of a surrounding of the vehicle, for example, a front area or a rear area is to be captured by the photoelectric conversion system 8.

Fig. 16C illustrates the photoelectric conversion system 8 in a case where an image of the front area of the vehicle (image capturing area 850) is to be captured. The vehicle information acquisition apparatus 810 transmits an instruction to the photoelectric conversion system 8 or the photoelectric conversion apparatus 1. According to such a configuration, an accuracy of the distance measurement can be further improved.

In the above, the example of the control to avoid the collision with other vehicles has been described, but the embodiment can also be applied to control for autonomous drive by following other vehicles, control for autonomous drive so as not to stray from its lane, or the like. Furthermore, the photoelectric conversion system 8 can be applied to not only a vehicle such as an automobile but also a movable object (mobile apparatus) such as, for example, a ship, aircraft, or an industrial robot. This movable object includes either or both of a drive force generation unit configured to generate a drive force to be mainly used for movement of the movable object and a rotating body to be mainly used for movement of the movable object. The drive force generation unit may be an engine, a motor, or the like. The rotating body may be a tire, a wheel, a screw of a vessel, a propeller of a flying vehicle. Moreover, the embodiment can be applied to not only the movable object but also an equipment that widely uses object recognition such as intelligent transport systems (ITS).

Modified Embodiments

The present disclosure is not limited to the above-described embodiments, and various modifications can be made.

For example, an example of adding some components of any of the embodiments to another embodiment and an example of replacing some components of any of the embodiments with those of another embodiment are also included in the embodiments of the present disclosure.

In addition, the equipment illustrated in the second embodiment described above represents a photoelectric conversion system example to which the photoelectric conversion apparatus may be applied, and the equipment and the photoelectric conversion system of the present disclosure to which the photoelectric conversion apparatus of the present disclosure can be applied are not limited to the configurations illustrated in Figs. 16A to 16C.

It is noted that any of the above-described embodiments is only an example of the embodiments for carrying out the present disclosure, and a technical scope of the present disclosure is not to be interpreted in a restrictive manner by these. That is, the present disclosure can be implemented in various manners without deviating from its technical concept or its main features.

The above-described embodiments can be modified as appropriate in a scope without departing from the technical concept. It is noted that the content disclosed in the present specification is not limited to described configurations in the present specification but also includes all matters that can be understood from the present specification and the accompanying drawings of the present specification. The content disclosed in the present specification also includes a complement set of concepts described in the present specification. That is, when a phrase "A is larger than B" is stated in the present specification, for example, even when a phrase "A is not larger than B" is omitted, it can be construed that the present specification discloses a notion that "A is not larger than B". This is because in a case where the phrase "A is larger than B" is stated, it is assumed that a case where "A is not larger than B" is taken into consideration.

Items described in the present disclosure include the following configurations.

Configuration 1

A photoelectric conversion apparatus including a plurality of pixels and a processing circuit configured to process signals read out from the plurality of pixels, in which

each of the plurality of pixels includes a photoelectric conversion element, a first amplification unit which includes an input node to which a signal from the photoelectric conversion element is input and which is configured to output an analog signal obtained by amplifying a signal level at the input node, and a holding capacitor unit which is configured to hold the analog signal output from the first amplification unit and which includes a plurality of capacitor elements, the photoelectric conversion apparatus including a selection unit configured to switch the capacitor element to be connected among the plurality of capacitor elements based on an inspection result of a signal output from the holding capacitor unit.

Configuration 2

The photoelectric conversion apparatus according to configuration 1, in which each of the plurality of pixels includes a second amplification unit which includes a second input node to which the signal output from the holding capacitor unit is input and which is configured to output a signal obtained by amplifying a signal level at the second input node.

Configuration 3

The photoelectric conversion apparatus according to configuration 1 or 2, in which

the photoelectric conversion element is arranged in a first substrate, and the holding capacitor unit is arranged in a second substrate, and
the first substrate and the second substrate are laminated.

Configuration 4

The photoelectric conversion apparatus according to any of configurations 1 to 3, in which the holding capacitor unit is constituted by combining the plurality of capacitor elements.

Configuration 5

The photoelectric conversion apparatus according to configuration 4, in which the plurality of capacitor elements are capacitances formed in a wiring structure. Configuration 6

The photoelectric conversion apparatus according to configuration 4, in which the plurality of capacitor elements are capacitances formed in a silicon substrate. Configuration 7

The photoelectric conversion apparatus according to any one of configurations 4 to 6, in which each of the plurality of capacitor elements has an identical capacitance value.

Configuration 8

The photoelectric conversion apparatus according to any one of configurations 4 to 7, in which the plurality of capacitor elements include, during a period in which some of the capacitor elements are selected, some other of the capacitor elements in a non-selected state.

Configuration 9

The photoelectric conversion apparatus according to configuration 8, in which the some other of the capacitor elements have a first terminal and a second terminal, and a fixed electric potential is supplied to both the first terminal and the second terminal. Configuration 10

The photoelectric conversion apparatus according to configuration 8 or 9, in which the holding capacitor unit includes a plurality of holding capacitor units, and the some other of the capacitor elements are arranged between the plurality of holding capacitor units in plan view.

Configuration 11

The photoelectric conversion apparatus according to any one of configurations 4 to 10, in which the plurality of capacitor elements are irregularly arranged.

Configuration 12

The photoelectric conversion apparatus according to any one of configurations 4 to 11, in which the holding capacitor unit is constituted by the plurality of capacitor elements that are not adjacent.

Configuration 13

The photoelectric conversion apparatus according to any one of configurations 1 to 12, in which

the holding capacitor unit includes at least a first capacitor unit and a second capacitor unit, and signals that are output during different periods from the first amplification units are held in the first capacitor unit and the second capacitor unit.

Configuration 14

The photoelectric conversion apparatus according to any one of configurations 1 to 13, in which

the holding capacitor unit is capable of holding a reference voltage, and
the reference voltage is a power source voltage, a ground voltage, or a variable voltage.

Configuration 15

The photoelectric conversion apparatus according to any one of configurations 1 to 14, further including

a determination unit configured to perform a determination based on the signal output from the holding capacitor unit, in which
the determination unit outputs the inspection result based on whether or not the signal output from the holding capacitor unit is within a predetermined range. Configuration 16

The photoelectric conversion apparatus according to any one of configurations 1 to 14, further including

a determination unit configured to determine the inspection result based on the signal output from the holding capacitor unit, in which
the determination unit determines the inspection result based on a comparison result between the signal output from the holding capacitor unit and an average value of signals output from at least some of the plurality of holding capacitor units.

Configuration 17

The photoelectric conversion apparatus according to any one of configurations 1 to 14, further including

a control line with which the holding capacitor unit is controlled, and
a determination unit configured to determine the inspection result based on a signal difference between one end of the control line and the other end of the control line.

Configuration 18

The photoelectric conversion apparatus according to configuration 15, in which when the signal output from the holding capacitor unit is within the predetermined range, some holding capacitor units among the plurality of holding capacitor units are not selected.

Configuration 19

An equipment including the photoelectric conversion apparatus according to any one of configurations 1 to 18, in which the equipment further includes at least any of

an optical apparatus corresponding to the photoelectric conversion apparatus,
a control apparatus configured to control the photoelectric conversion apparatus,
a processing apparatus configured to process a signal output from the photoelectric conversion apparatus,
a display apparatus configured to display information acquired in the photoelectric conversion apparatus,
a storage device configured to store information acquired in the photoelectric conversion apparatus, and
a mechanical apparatus arranged to operate based on information acquired in the photoelectric conversion apparatus.

Configuration 20

An inspection method of a photoelectric conversion apparatus including a plurality of pixels and a processing circuit configured to process signals read out from the plurality of pixels, in which each of the plurality of pixels includes a photoelectric conversion element, a first amplification unit which includes an input node to which a signal from the photoelectric conversion element is input and which is configured to output an analog signal obtained by amplifying a signal level at the input node, and a holding capacitor unit which is configured to hold the analog signal output from the first amplification unit and which includes a plurality of capacitor elements, the inspection method including

a first operation of supplying a predetermined voltage to the holding capacitor unit;
a second operation of reading out a signal from the holding capacitor unit to which the predetermined voltage is supplied by the first operation; and
a third operation of performing an inspection of the photoelectric conversion apparatus based on the signal read out by the second operation. Configuration 21

The inspection method of the photoelectric conversion apparatus according to configuration 20, in which in the first operation, the predetermined voltage that is common is supplied to the holding capacitor unit of each of the plurality of pixels. Configuration 22

The inspection method of the photoelectric conversion apparatus according to configuration 20, in which in the first operation, a voltage having a first voltage value is supplied to the holding capacitor unit of some pixels of the plurality of pixels, and a voltage having a second voltage value that is different from the first voltage value is supplied to the holding capacitor unit of some other pixels of the plurality of pixels.

The present disclosure aims to provide a technique that is advantageous to suppress the image quality degradation caused by the variations and defects related to the capacitor elements and to improve the image capturing performance in the photoelectric conversion apparatus provided with the global electronic shutter function of the voltage holding type.

Various embodiments have been described in detail above but it will be understood that the present disclosure is not limited to these embodiments and encompasses all modifications, variants, alternatives and equivalents falling within the scope of the appended claims.

## Claims

1. A photoelectric conversion apparatus (10) comprising: a plurality of pixels (30); and a processing circuit (50) configured to process signals read out from the plurality of pixels (30), wherein
   each of the plurality of pixels (30) includes a photoelectric conversion element (115, 116), a first amplification unit (111) which includes an input node to which a signal from the photoelectric conversion element (115, 116) is input and which is configured to output an analog signal obtained by amplifying a signal level at the input node, and a holding capacitor unit (240) which is configured to hold the analog signal output from the first amplification unit (111) and which includes a plurality of capacitor elements (mem), the photoelectric conversion apparatus (10) further comprising:
   a selection unit (220) configured to switch the capacitor element (mem) to be connected among the plurality of capacitor elements (mem) based on an inspection result of a signal output from the holding capacitor unit (240).

2. The photoelectric conversion apparatus (10) according to claim 1, wherein each of the plurality of pixels (30) includes a second amplification unit (211) which includes a second input node to which the signal output from the holding capacitor unit (240) is input and which is configured to output a signal obtained by amplifying a signal level at the second input node.

3. The photoelectric conversion apparatus (10) according to claim 1 or 2, wherein

   the photoelectric conversion element (115, 116) is arranged in a first substrate (100), and the holding capacitor unit (240) is arranged in a second substrate (200), and
   the first substrate (100) and the second substrate (200) are laminated.

4. The photoelectric conversion apparatus (10) according to any one of claims 1 to 3, wherein the holding capacitor unit (240) is constituted by combining the plurality of capacitor elements (mem).

5. The photoelectric conversion apparatus (10) according to claim 4, wherein the plurality of capacitor elements (mem) are capacitances formed in a wiring structure.

6. The photoelectric conversion apparatus (10) according to claim 4, wherein the plurality of capacitor elements (mem) are capacitances formed in a silicon substrate.

7. The photoelectric conversion apparatus (10) according to any one of claims 4 to 6, wherein each of the plurality of capacitor elements (mem) has an identical capacitance value.

8. The photoelectric conversion apparatus (10) according to any one of claims 4 to 7, wherein the plurality of capacitor elements (mem) include, during a period in which some of the capacitor elements are selected, some other of the capacitor elements in a non-selected state.

9. The photoelectric conversion apparatus (10) according to claim 8, wherein the some other of the capacitor elements (mem) have a first terminal and a second terminal, and a fixed electric potential is supplied to both the first terminal and the second terminal.

10. The photoelectric conversion apparatus (10) according to claim 8 or 9, wherein the holding capacitor unit (240) includes a plurality of holding capacitor units, and the some other of the capacitor elements (mem) are arranged between the plurality of holding capacitor units in plan view.

11. The photoelectric conversion apparatus (10) according to any one of claims 4 to 10, wherein the plurality of capacitor elements (mem) are irregularly arranged.

12. The photoelectric conversion apparatus (10) according to any one of claims 4 to 11, wherein the holding capacitor unit (240) is constituted by the plurality of capacitor elements (mem) that are not adjacent.

13. The photoelectric conversion apparatus (10) according to any one of claims 1 to 12, wherein

the holding capacitor unit (240) includes at least a first capacitor unit and a second capacitor unit, and
signals that are output during different periods from the first amplification units are held in the first capacitor unit and the second capacitor unit.

14. The photoelectric conversion apparatus (10) according to any one of claims 1 to 13, wherein

the holding capacitor unit (240) is capable of holding a reference voltage, and
the reference voltage is a power source voltage, a ground voltage, or a variable voltage.

15. The photoelectric conversion apparatus (10) according to any one of claims 1 to 14, further comprising:

a determination unit configured to perform a determination based on the signal output from the holding capacitor unit (240), wherein
the determination unit outputs the inspection result based on whether or not the signal output from the holding capacitor unit (240) is within a predetermined range.

16. The photoelectric conversion apparatus (10) according to any one of claims 1 to 14, further comprising:

a determination unit configured to determine the inspection result based on the signal output from the holding capacitor unit, wherein
the determination unit determines the inspection result based on a comparison result between the signal output from the holding capacitor unit (240) and an average value of signals output from at least some of the plurality of holding capacitor units.

17. The photoelectric conversion apparatus (10) according to any one of claims 1 to 14, further comprising:

a control line with which the holding capacitor unit (240) is controlled; and
a determination unit configured to determine the inspection result based on a signal difference between one end of the control line and the other end of the control line.

18. The photoelectric conversion apparatus (10) according to claim 15, wherein when the signal output from the holding capacitor unit (240) is within the predetermined range, some holding capacitor units among the plurality of holding capacitor units are not selected.

19. An equipment (9191) comprising the photoelectric conversion apparatus (10, 930) according to any one of claims 1 to 18, wherein the equipment (9191) further comprises at least any of

an optical apparatus (940) corresponding to the photoelectric conversion apparatus,
a control apparatus (950) configured to control the photoelectric conversion apparatus,
a processing apparatus (960) configured to process a signal output from the photoelectric conversion apparatus,
a display apparatus (970) configured to display information acquired in the photoelectric conversion apparatus,
a storage device (980) configured to store information acquired in the photoelectric conversion apparatus, and
a mechanical apparatus (990) arranged to operate based on information acquired in the photoelectric conversion apparatus.

20. An inspection method of a photoelectric conversion apparatus (10) including a plurality of pixels (30) and a processing circuit (50) configured to process signals read out from the plurality of pixels (30), in which each of the plurality of pixels (30) includes a photoelectric conversion element (115, 116), a first amplification unit (111) which includes an input node to which a signal from the photoelectric conversion element (115, 116) is input and which is configured to output an analog signal obtained by amplifying a signal level at the input node, and a holding capacitor unit (24) which is configured to hold the analog signal output from the first amplification unit (111) and which includes a plurality of capacitor elements (mem), the inspection method comprising:

a first operation of supplying a predetermined voltage to the holding capacitor unit (240);
a second operation of reading out a signal from the holding capacitor unit (240) to which the predetermined voltage is supplied by the first operation; and
a third operation of performing an inspection of the photoelectric conversion apparatus (10) based on the signal read out by the second operation.

21. The inspection method of the photoelectric conversion apparatus according to claim 20, wherein in the first operation, the predetermined voltage that is common is supplied to the holding capacitor unit (240) of each of the plurality of pixels (30).

22. The inspection method of the photoelectric conversion apparatus according to claim 20, wherein in the first operation, a voltage having a first voltage value is supplied to the holding capacitor unit (240) of some pixels of the plurality of pixels, and a voltage having a second voltage value that is different from the first voltage value is supplied to the holding capacitor unit (240) of some other pixels of the plurality of pixels.

# FIG. 1

110

100

200

210

300

310

# FIG. 2

20 120 30

100
110

PIXEL CONTROL CIRCUIT

VERTICAL SCANNING CIRCUIT

| PIXEL | PIXEL |
| PIXEL | PIXEL |

21 220 40

200
210

MEMORY CONTROL CIRCUIT

MEMORY VERTICAL SCANNING CIRCUIT

ELECTRIC CURRENT SOURCE
230

| PIXEL MEMORY | PIXEL MEMORY |
| PIXEL MEMORY | PIXEL MEMORY |

22 320

300
310

SIGNAL PROCESSING CONTROL CIRCUIT

COLUMN CONTROL CIRCUIT

RAMP GENERATOR
340

ELECTRIC CURRENT SOURCE
330

COLUMN SIGNAL PROCESSING CIRCUIT

COLUMN SIGNAL PROCESSING CIRCUIT

50

10

IMAGE DATA

# FIG. 3

EP 4 687 348 A1

FIG. 4

230

MVDD

232

VBIAS1

231

MGND

330

AVDD

332

VBIAS2

331

AGND

# FIG. 5

EP 4 687 348 A1

# FIG. 6

# FIG. 7

# FIG. 8

# FIG. 9

# FIG. 10

40

WR_N-2

WR_SA-2

WR_SAB-2

| Nmem1 | Smem-A1 | Smem-AB1 |

DF

WR_N-3

WR_SA-3

WR_SAB-3

| Smem-AB2 | Nmem2 | Smem-A2 |

WR_N-4

WR_SA-4

WR_SAB-4

| Smem-A3 | Smem-AB3 | Nmem3 |

FIG. 11

# FIG. 12

# FIG. 13

## FIG. 14

EP 4 687 348 A1

# FIG. 15

## FIG. 16A

## FIG. 16B

PHOTOELECTRIC CONVERSION APPARATUS — 10

IMAGE PROCESSING UNIT — 801

PARALLAX ACQUISITION UNIT — 802

DISTANCE ACQUISITION UNIT — 803

COLLISION DETERMINATION UNIT — 804

VEHICLE INFORMATION ACQUISITION APPARATUS — 810

CONTROL ECU — 820

ALARM APPARATUS — 830

## FIG. 16C

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/362270 A1 (HU JOSEPH [US] ET AL) 11 December 2014 (2014-12-11) | 1,20-22 | INV.<br>H04N25/68 |
| Y | * paragraph [0005] - paragraph [0006]; figure 3 *<br>* paragraph [0056] - paragraph [0058]; figures 4,6,5 *<br>----- | 2-19 | H04N25/771<br>H04N25/79 |
| Y | US 2018/295303 A1 (MURAO FUMIHIDE [JP]) 11 October 2018 (2018-10-11)<br>* paragraph [0083] - paragraph [0085]; figures 3,6 *<br>* paragraph [0067] - paragraph [0068]; figure 3 *<br>----- | 2-19 | |
| A | US 2023/412945 A1 (ONO TOSHIAKI [JP]) 21 December 2023 (2023-12-21)<br>* paragraph [0111] - paragraph [0124]; figures 7,8 *<br>----- | 1-20 | |
| A | US 2024/089639 A1 (ZUO LIANG [US] ET AL) 14 March 2024 (2024-03-14)<br>* paragraph [0026] - paragraph [0049]; figures 1,3,4 *<br>----- | 1-20 | TECHNICAL FIELDS SEARCHED (IPC)<br><br>H04N |

The present search report has been drawn up for all claims

| Place of search | Date of completion of the search | Examiner |
|---|---|---|
| Munich | 20 November 2025 | Dinov, Vassil |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.........................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 18 5996

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2025

| Patent document cited in search report | | Publication date | Patent family member(s) | | Publication date |
|---|---|---|---|---|---|
| US 2014362270 A1 | | 11-12-2014 | NONE | | |
| US 2018295303 A1 | | 11-10-2018 | JP | 2018182462 A | 15-11-2018 |
| | | | US | 2018295303 A1 | 11-10-2018 |
| US 2023412945 A1 | | 21-12-2023 | CN | 116325782 A | 23-06-2023 |
| | | | EP | 4246958 A1 | 20-09-2023 |
| | | | JP | WO2022102433 A1 | 19-05-2022 |
| | | | US | 2023412945 A1 | 21-12-2023 |
| | | | WO | 2022102433 A1 | 19-05-2022 |
| US 2024089639 A1 | | 14-03-2024 | CN | 117676362 A | 08-03-2024 |
| | | | TW | 202412508 A | 16-03-2024 |
| | | | US | 2024089639 A1 | 14-03-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023083030 A